(19) 

Europäisches
Patentamt
European
Patent Office
Office européen
des brevets

(11) **EP 3 875 976 A1**

(12) **EUROPEAN PATENT APPLICATION**
published in accordance with Art. 153(4) EPC

(43) Date of publication:
 08.09.2021 Bulletin 2021/36

(21) Application number: 19878143.7

(22) Date of filing: 31.10.2019

(51) Int Cl.:
 *G01R 31/392* (2019.01)    *B60L 50/50* (2019.01)
 *G01R 31/367* (2019.01)    *G06Q 10/04* (2012.01)
 *H01M 10/48* (2006.01)     *H02J 7/00* (2006.01)

(86) International application number:
 **PCT/JP2019/042707**

(87) International publication number:
 **WO 2020/090949 (07.05.2020 Gazette 2020/19)**

(84) Designated Contracting States:
 **AL AT BE BG CH CY CZ DE DK EE ES FI FR GB
 GR HR HU IE IS IT LI LT LU LV MC MK MT NL NO
 PL PT RO RS SE SI SK SM TR**
 Designated Extension States:
 **BA ME**
 Designated Validation States:
 **KH MA MD TN**

(30) Priority: 31.10.2018  JP 2018205734

(71) Applicant: **GS Yuasa International Ltd.
 Kisshoin, Minami-ku,
 Kyoto-shi, Kyoto 601-8520 (JP)**

(72) Inventor: **UKUMORI, Nan
 Kyoto-shi, Kyoto 601-8520 (JP)**

(74) Representative: **Grünecker Patent- und
 Rechtsanwälte
 PartG mbB
 Leopoldstraße 4
 80802 München (DE)**

(54) **ELECTRICITY STORAGE ELEMENT EVALUATING DEVICE, COMPUTER PROGRAM,
 ELECTRICITY STORAGE ELEMENT EVALUATING METHOD, LEARNING METHOD, AND
 CREATION METHOD**

(57)    Provided are an energy storage device evaluation device, a computer program, an energy storage device evaluation method, a learning method, and a generation method capable of optimally distributing a load in consideration of degradation of the energy storage device. The energy storage device evaluation device includes an action selection unit that selects an action including a change in the load state of the energy storage device based on action evaluation information, a state acquisition unit that acquires a state of the energy storage device when the selected action is executed, a reward acquisition unit that acquires a reward when the selected action is executed, an update unit that updates the action evaluation information based on the acquired state and reward, and an evaluation unit that evaluates the state of the energy storage device by executing the action based on the updated action evaluation information.

Fig. 2

**Description**

TECHNICAL FIELD

The present invention relates to an energy storage device evaluation device, a computer program, an energy storage device evaluation method, a learning method, and a generation method.

BACKGROUND ART

Various industries such as the transportation industry, the logistics industry, and the shipping industry are considering the electrification of moving objects including vehicles and flying vehicles. As a business entity that owns many electric vehicles, it is desirable to avoid premature degradation of the energy storage device mounted on the electric vehicle.
Patent Document 1 discloses a technique for increasing the utilization rate of an in-vehicle storage battery in energy management utilizing the in-vehicle storage battery.

PRIOR ART DOCUMENT

PATENT DOCUMENT

Patent Document 1: JP-A-2017-46498

SUMMARY OF THE INVENTION

PROBLEMS TO BE SOLVED BY THE INVENTION

Degradation of the energy storage device changes depending on the environment in which the energy storage device is used (in the case of an electric vehicle, a running state, a flight state, and a usage environment). If a particular electric vehicle is used excessively, the energy storage device mounted on the electric vehicle degrades at an early stage.
An object of the present invention is to provide an energy storage device evaluation device, a computer program, an energy storage device evaluation method, a learning method, and a generation method capable of optimally distributing a load in consideration of degradation of the energy storage device.

MEANS FOR SOLVING THE PROBLEMS

The energy storage device evaluation device includes an action selection unit that selects an action including a change in a load state of an energy storage device based on action evaluation information, a state acquisition unit that acquires a state of the energy storage device when the action selected by the action selection unit is executed, a reward acquisition unit that acquires a reward when the action selected by the action selection unit is executed, an update unit that updates the action evaluation information based on the state acquired by the state acquisition unit and the reward acquired by the reward acquisition unit, and an evaluation unit that evaluates the state of the energy storage device by executing an action based on the action evaluation information updated by the update unit.
The computer program causes a computer to execute the processing of selecting an action including a change in a load state of an energy storage device based on action evaluation information, acquiring a state of the energy storage device when the selected action is executed, acquiring a reward when the selected action is executed, updating the action evaluation information based on the acquired state and reward, and evaluating the state of the energy storage device by executing an action based on the updated action evaluation information.
The energy storage device evaluation method includes selecting an action including a change in a load state of an energy storage device based on action evaluation information, acquiring a state of the energy storage device when the selected action is executed, acquiring a reward when the selected action is executed, updating the action evaluation information based on the acquired state and reward, and evaluating the state of the energy storage device by executing an action based on the updated action evaluation information.
The learning method includes selecting an action including a change in a load state of an energy storage device based on action evaluation information, acquiring a state of the energy storage device when the selected action is executed, acquiring a reward when the selected action is executed, and updating the action evaluation information based on the acquired reward to learn an action corresponding to the state of the energy storage device.
The generation method includes selecting an action including a change in a load state of an energy storage device based on action evaluation information, acquiring a state of the energy storage device when the selected action is executed, acquiring a reward when the selected action is executed, and updating the action evaluation information based on the acquired reward to generate the action evaluation information.

ADVANTAGES OF THE INVENTION

With the above configuration, the load can be optimally distributed in consideration of degradation of the energy storage device.

BRIEF DESCRIPTION OF THE DRAWINGS

Fig. 1 is a schematic diagram showing an example of a configuration of an energy storage device evaluation system.
Fig. 2 is a block diagram showing an example of a configuration of an energy storage device evaluation server.
Fig. 3A is a schematic view showing an example of load power of an energy storage device.
Fig. 3B is a schematic view showing an example of load power of the energy storage device.
Fig. 4 is a schematic diagram showing an example of an environmental temperature of the energy storage device.
Fig. 5 is a schematic diagram showing an operation of an SOH estimation unit.
Fig. 6 is a schematic diagram showing an example of transition of an SOC of the energy storage device.
Fig. 7 is a schematic diagram showing an example of reinforcement learning.
Fig. 8 is a schematic diagram showing an example of a service area of a logistics/shipping service.
Fig. 9 is a schematic diagram showing an example of a vehicle allocation state of an electric vehicle for each area.
Fig. 10 is a schematic diagram showing a relationship between an electric vehicle and an energy storage device mounted on the electric vehicle.
Fig. 11 is a schematic diagram showing an example of a configuration of an evaluation value table.
Fig. 12 is a schematic diagram showing an example of evaluation values in the evaluation value table.
Fig. 13 is a schematic diagram showing an example of a configuration of a neural network model of the present embodiment.
Fig. 14 is a schematic diagram showing an example of switching areas where electric vehicles are allocated.
Fig. 15 is a schematic diagram showing an example of a service content of an energy storage device replacement service.
Fig. 16 is a schematic diagram showing an example of replacement of an energy storage device.
Fig. 17 is a schematic diagram showing an example of changing a load state of an energy storage device in a stationary energy storage device operation monitoring service.
Fig. 18 is a schematic diagram showing an example of load switching.
Fig. 19 is a schematic diagram showing a first example of a state transition of reinforcement learning.
Fig. 20 is a schematic diagram showing a second example of a state transition of reinforcement learning.
Fig. 21 is a schematic diagram showing an example of transition of SOH by an operation method obtained by reinforcement learning when an SOH estimation unit is used since before start of operation.
Fig. 22 is a schematic diagram showing an example of the transition of SOH by the operation method obtained by reinforcement learning when a life prediction simulator is generated using data in an initial stage of operation.
Fig. 23 is a schematic diagram showing an example of the transition of SOH by the operation method obtained by reinforcement learning when the life prediction simulator is not used.
Fig. 24 is a flowchart showing an example of a processing procedure of reinforcement learning.

MODE FOR CARRYING OUT THE INVENTION

The energy storage device evaluation device includes an action selection unit that selects an action including a change in a load state of an energy storage device based on action evaluation information, a state acquisition unit that acquires a state of the energy storage device when the action selected by the action selection unit is executed, a reward acquisition unit that acquires a reward when the action selected by the action selection unit is executed, an update unit that updates the action evaluation information based on the state acquired by the state acquisition unit and the reward acquired by the reward acquisition unit, and an evaluation unit that evaluates the state of the energy storage device by executing an action based on the action evaluation information updated by the update unit.

The computer program causes a computer to execute the processing of selecting an action including a change in a load state of an energy storage device based on action evaluation information, acquiring a state of the energy storage device when the selected action is executed, acquiring a reward when the selected action is executed, updating the action evaluation information based on the acquired state and reward, and evaluating the state of the energy storage device by executing an action based on the updated action evaluation information.

The energy storage device evaluation method includes selecting an action including a change in a load state of an energy storage device based on action evaluation information, acquiring a state of the energy storage device when the selected action is executed, acquiring a reward when the selected action is executed, updating the action evaluation information based on the acquired state and reward, and evaluating the state of the energy storage device by executing an action based on the updated action evaluation information.

The learning method includes selecting an action including a change in a load state of an energy storage device based on action evaluation information, acquiring a state of the energy storage device when the selected action is executed, acquiring a reward when the selected action is executed, and updating the action evaluation information based on the acquired reward to learn an action corresponding to the state of the energy storage device.

The generation method includes selecting an action including a change in a load state of an energy storage device based on action evaluation information, acquiring a state of the energy storage device when the selected action is executed, acquiring a reward when the selected action is executed, and updating the action evaluation information based on the acquired reward to generate the action evaluation information.

The action selection unit selects an action including a change in the load state of the energy storage device based on the action evaluation information. The action evaluation information is an action value function or table (table) that determines the evaluation value of the action in a certain state of the environment in reinforcement learning, and means the Q value or the Q function in Q-learning. The load state of the energy storage device includes physical quantities such as current, voltage, and power when the energy storage device is charged or discharged. Further, the temperature of the energy storage device can be included in the load state. Changes in the load state include change patterns such as current, voltage, power or temperature (including fluctuation range, average value, peak value, etc.), change in the location where the energy storage device is used, change in the use state (for example, change between use state and stored state), and so on. Considering that each of the plurality of energy storage devices has an individual load state, changing the load state of the energy storage device corresponds to load distribution. The action selection unit corresponds to an agent in reinforcement learning, and can select the action with the highest evaluation in the action evaluation information.

The state acquisition unit acquires the state of the energy storage device when the action selected by the action selection unit is executed. When the action selected by the action selection unit is executed, the state of the environment changes. The state acquisition unit acquires the changed state. The state of the energy storage device may be an SOH (State Of Health), or may be a combination of current, voltage, temperature, battery thickness, time series data thereof, and each index at a certain time point, which are leading indicators of the SOH. In the present specification, the SOH refers to the dischargeable electric capacity maintenance rate, the internal resistance increase rate, the dischargeable power capacity maintenance rate, etc., and the combination or time-series transition of these values, as compared with the values in the initial state. It is desirable to use the measured value for the SOH, but it may be a value estimated from the leading indicator or the SOH measured last time. Especially when it is an estimated value, it is desirable to express SOH as a probability distribution.

The reward acquisition unit acquires the reward when the action selected by the action selection unit is executed. The reward acquisition unit acquires a high value (positive value) when the action selection unit exerts a desired result on the environment. When the reward is zero, there is no reward, and when the reward is negative, there is a penalty.

The update unit updates the action evaluation information based on the acquired state and reward. More specifically, the update unit corresponds to an agent in reinforcement learning and updates the action evaluation information in the direction of maximizing the reward for the action. This makes it possible to learn the action that is expected to have the maximum value in a certain state of the environment.

The evaluation unit executes an action based on the action evaluation information updated by the update unit to evaluate the state of the energy storage device. As a result, an action including a change in the load state can be obtained by reinforcement learning with respect to the SOH of the energy storage device, for example, and the SOH of the energy storage device can be evaluated as a result of the action including the change in the load state. By evaluating each of the plurality of energy storage devices, the load of the energy storage devices can be optimally distributed in consideration of the degradation of the energy storage devices, and the cost can be reduced as a whole.

The energy storage device evaluation device is designed to move a moving object mounted with the energy storage device within one of a plurality of moving areas, and the action can include switching from a moving area in which the moving object moves to another moving area that is different from the moving area.

A moving object mounted with an energy storage device is designed to move within one of a plurality of moving areas. For example, in the logistics industry or the shipping industry, a service providing area can be divided into a plurality of moving areas, and a moving object (for example, an electric vehicle) to be provided for the service can be determined for each moving area. For example, moving objects a1, a2,... can be allocated to a moving area A, and moving objects b1, b2,... can be allocated to a moving area B. The same applies to other moving areas.

The action includes switching from a moving area in which a moving object moves to another moving area different from the moving area. When the road network is divided into a plurality of moving areas, it is considered that the environment in a specific moving area is different from that in other moving areas, such as many slopes, many intersections with traffic lights, and many highways, and therefore, it is considered that the load state of the energy storage device mounted on the moving object is also different. When a moving object allocated to a moving area is moved within the moving area, the weight of the load on the energy storage device differs for each moving area, and the energy storage device of the moving object in a specific moving area may degrade faster.

By learning the switching of the moving area in which the moving object moves by reinforcement learning, the SOH of the energy storage device can be evaluated as a result of the switching of the moving area. By evaluating each of the plurality of energy storage devices, the load of the energy storage devices can be optimally distributed in consideration of the degradation of the energy storage devices, and the cost can be reduced as a whole.

The energy storage device evaluation device includes a first reward calculation unit that calculates a reward based on the distance between the moving object areas due to switching of the moving area, and the reward acquisition unit can acquire the reward calculated by the first reward calculation unit.

The first reward calculation unit calculates the reward based on the distance between the moving object areas due to the switching of the moving area. The reward acquisition unit acquires the reward calculated by the first reward calculation unit. For example, it is considered that the longer the distance, the higher the cost tends to become due to the switching of the moving area, so that the calculation can be made so that the longer the distance, the smaller the reward, or the negative reward (penalty). As a result, it is possible to suppress an increase in the cost of the entire system including the plurality of energy storage devices.

In the energy storage device evaluation device, the action can include switching between a mounted state in which the energy storage device is mounted on the moving object and a stored state in which the energy storage device is removed from the moving object.

The action includes switching between the mounted state in which the energy storage device is mounted on the moving object and the stored state in which the energy storage device is removed from the moving object. For example, in the energy storage device replacement service, a plurality of energy storage devices are stored in advance, and when a state of charge (SOC) of the energy storage device mounted on the moving object decreases, the energy storage device of the moving object is replaced with a fully charged energy storage device. The weight of the load state of the energy storage device differs between the mounted state and the stored state.

By learning the switching between the mounted state and the stored state by reinforcement learning, the SOH of the energy storage device can be evaluated as a result of the switching between the mounted state and the stored state. By evaluating each of the plurality of energy storage devices, the load of the energy storage devices can be optimally distributed in consideration of the degradation of the energy storage devices, and the cost can be reduced as a whole.

In the energy storage device evaluation device, the energy storage device is connected to one of a plurality of loads, and the action can include switching from a load connected to the energy storage device to another load different from the load.

The energy storage device is connected to one of a plurality of loads. That is, a separate load is connected to each of the plurality of energy storage devices in a power generation facility or a power demand facility. Since the power required for the electric equipment that is the load of the energy storage device fluctuates depending on the operating state and the environmental state, and the power required for the energy storage device also fluctuates, the weight of the load state on the energy storage device differs depending on the load connected to the energy storage device. When the loads are fixedly connected to the plurality of energy storage devices, respectively, the weight of the load on the energy storage device differs depending on the load, and the degradation of a specific energy storage device may be accelerated.

The action includes switching from a load connected to the energy storage device to another load different from the load. By learning load switching by reinforcement learning, the SOH of the energy storage device can be evaluated as a result of load switching. By evaluating each of the plurality of energy storage devices, the load of the energy storage devices can be optimally distributed in consideration of the degradation of the energy storage devices, and the cost can be reduced as a whole.

The energy storage device evaluation device includes a second reward calculation unit that calculates a reward based on the number of times of switching, and the reward acquisition unit can acquire the reward calculated by the second reward calculation unit.

The second reward calculation unit calculates the reward based on the number of times of switching. The reward acquisition unit acquires the reward calculated by the second reward calculation unit. For example, if priority is given to the operation of maintaining a high average SOH of the energy storage devices in the entire system including a plurality of energy storage devices, the calculation can be made so that the reward is not small or negative (penalty) even if the number of times of switching is large, at the expense of a slight cost increase due to the increase in the number of times of switching. On the other hand, if priority is given to the operation of reducing the switching cost for the entire system including a plurality of energy storage devices, the calculation can be made so that the reward is a relatively large value as the number of times of switching is smaller, at the expense of a slight decrease in the average SOH of the energy storage devices due to the reduction in the number of times of switching. As a result, optimum operation can be realized.

The energy storage device evaluation device includes a third reward calculation unit that calculates a reward based on the degree of decrease in SOH of the energy storage device, and the reward acquisition unit can acquire the reward calculated by the third reward calculation unit.

The third reward calculation unit calculates a reward based on the degree of decrease in SOH of the energy storage device. The reward acquisition unit acquires the reward calculated by the third reward calculation unit. The degree of decrease in SOH can be, for example, a decrease rate in the current SOH with respect to the past SOH. For example, if the degree of decrease in SOH is greater than a threshold value (when the decrease rate is large), the reward can be a negative value (penalty). In addition, when the degree of decrease in SOH is smaller than the threshold value (when the decrease rate is small), the reward can be a positive value. As a result, optimum operation of the energy storage device can be realized while suppressing a decrease in SOH of the energy storage device.

The energy storage device evaluation device includes a fourth reward calculation unit that calculates a reward based on whether or not the state of the energy storage device has reached the end of its life, and the reward acquisition unit can acquire the reward calculated by the fourth reward calculation unit.

The fourth reward calculation unit calculates the reward based on whether or not the state of the energy storage device has reached the end of its life. The reward acquisition unit acquires the reward calculated by the fourth reward calculation unit. For example, when the SOH of the energy storage device does not fall below an EOL (End Of Life), the reward can be a positive value, and when the SOH falls below the EOL, the reward can be a negative value (penalty). As a result, optimum operation can be realized so as to reach the expected life of the energy storage device (for example, 10 years, 15 years, etc.).

The energy storage device evaluation device includes a power information acquisition unit that acquires load power information of the energy storage device, an SOC transition estimation unit that estimates SOH transition of the energy storage device based on the load power information acquired by the power information acquisition unit and the action selected by the action selection unit, and an SOC estimation unit that estimates SOH of the energy storage device based on the SOC transition estimated by the SOC transition estimation unit, and the evaluation unit can evaluate the state including the SOH of the energy storage device based on the SOH estimated by the SOH estimation unit.

The power information acquisition unit acquires load power information of the energy storage device. The load power information is information representing a transition of the load power over a predetermined period, and includes charge power when the energy storage device is charged, and includes discharge power when the energy storage device is discharged. The predetermined period can be one day, one week, one month, spring, summer, autumn, winter, one year, or the like.

The SOC transition estimation unit estimates the SOC transition of the energy storage device based on the load power information acquired by the power information acquisition unit and the action selected by the action selection unit. When the energy storage device is charged in a predetermined period, the SOC increases. On the other hand, when the energy storage device is discharged, the SOC decreases. During a predetermined period, the energy storage device may not be charged or discharged (for example, at night). As a result, the SOC transition can be estimated over a predetermined period.

The SOH estimation unit estimates the SOH of the energy storage device based on the estimated SOC transition. The evaluation unit evaluates the state including SOH of the energy storage device based on the SOH estimated by the SOH estimation unit. The degradation value Qdeg of the energy storage device after a predetermined period can be expressed by the sum of the energization degradation value Qcur and the non-energization degradation value Qcnd. When the elapsed time is expressed by t, the non-energization degradation value Qcnd can be obtained by, for example, Qcnd = K1 $\times \sqrt{(t)}$. Here, the coefficient K1 is a function of SOC. Further, the energization degradation value Qcur can be obtained by, for example, Qcur = K2 $\times$ (SOC fluctuation amount). Here, the coefficient K2 is a function of SOC. Assuming that the SOH at the start point of a predetermined period is SOH1 and the SOH at the end point is SOH2, the SOH can be estimated by SOH2 = SOH1- Qdeg.

Note that, the SOC transition estimation unit and the SOH estimation unit described above can be prepared in advance before the start of operation of a system including a plurality of energy storage devices.

This makes it possible to estimate the SOH after the lapse of a predetermined period in the future. Further, if the degradation value after the lapse of the predetermined period is calculated based on the estimated SOH, the SOH after the lapse of the predetermined period can be further estimated. By repeating the estimation of SOH every predetermined period, it is also possible to estimate whether or not the energy storage device reaches the end of its life (whether or not SOH is EOL or less) at the expected life of the energy storage device (for example, 10 years, 15 years, etc.).

The energy storage device evaluation device includes a power information acquisition unit that acquires load power information of the energy storage device, an SOH acquisition unit that acquires an SOH of the energy storage device, and a generation unit that generates an SOH estimation unit that estimates the SOH of the energy storage device based on the load power information acquired by the power information acquisition unit and the SOH acquired by the SOH acquisition unit, and the evaluation unit can evaluate the state including the SOH of the energy storage device based on SOH estimation of the SOH estimation unit generated by the generation unit.

The power information acquisition unit acquires load power information of the energy storage device. The load power information is information representing a transition of the load power over a predetermined period, and includes charge power when the energy storage device is charged, and includes discharge power when the energy storage device is discharged. The predetermined period can be one day, one week, one month, spring, summer, autumn, winter, one year, or the like. The SOH acquisition unit acquires the SOH of the energy storage device.

The generation unit generates an SOH estimation unit that estimates the SOH of the energy storage device based on the load power information acquired by the power information acquisition unit and the SOH acquired by the SOH acquisition unit. The evaluation unit evaluates the state including the SOH of the energy storage device based on the SOH estimation of the SOH estimation unit generated by the generation unit. For example, an SOH estimation unit, which collects, after the start of operation of a system including a plurality of energy storage devices, the acquired load power information and the SOH of the energy storage device, and estimates the state including the collected SOH of the energy storage device with respect to the collected load power information, is generated. Specifically, parameters for estimating SOH are set. For example, the degradation value Qdeg of the energy storage device after a predetermined period can be expressed by the sum of the energization degradation value Qcur and the non-energization degradation value Qcnd, and when the elapsed time is expressed by t, the non-energization degradation value Qcnd can be obtained by, for example, $Qcnd = K1 \times \sqrt{(t)}$. Further, the energization degradation value Qcur can be obtained by, for example, $Qcur = K2 \times \sqrt{(t)}$. Here, the parameters to be set are the coefficient K1 and the coefficient K2, and are represented by the SOC function.

As a result, it is possible to save the trouble of developing an SOH estimation unit (for example, an SOH simulator) that estimates the SOH of the energy storage device before operating the system. In addition, since the SOH estimation unit is generated by collecting the load power information after the system operation starts and the state including the SOH of the energy storage device, the development of a highly accurate SOH estimation unit (for example, SOH simulator) according to the operating environment can be expected.

Further, after the SOH estimation unit is generated, the SOH after a lapse of a predetermined period in the future can be estimated. Further, if the degradation value after the lapse of the predetermined period is calculated based on the estimated SOH, the SOH after the lapse of the predetermined period can be further estimated. By repeating the estimation of SOH every predetermined period, it is also possible to estimate whether or not the energy storage device reaches the end of its life (whether or not SOH is EOL or less) at the expected life of the energy storage device (for example, 10 years, 15 years, etc.).

The energy storage device evaluation device includes a temperature information acquisition unit that acquires environmental temperature information of the energy storage device, and the SOH estimation unit can estimate the SOH of the energy storage device based on the environmental temperature information.

The temperature information acquisition unit acquires the environmental temperature information of the energy storage device. The environmental temperature information is information representing the transition of the environmental temperature over a predetermined period.

The SOH estimation unit estimates the SOH of the energy storage device based on the environmental temperature information. The degradation value Qdeg of the energy storage device after a predetermined period can be expressed by the sum of the energization degradation value Qcur and the non-energization degradation value Qcnd. When the elapsed time is expressed by t, the non-energization degradation value Qcnd can be obtained by, for example, $Qcnd = K1 \times \sqrt{(t)}$. Here, the coefficient K1 is a function of SOC and temperature T. Further, the energization degradation value Qcur can be obtained by, for example, $Qcur = K2 \times \sqrt{(t)}$. Here, the coefficient K2 is a function of SOC and temperature T. Assuming that the SOH at the start point of a predetermined period is SOH1 and the SOH at the end point is SOH2, the SOH can be estimated by SOH2 = SOH1- Qdeg.

This makes it possible to estimate the SOH after the lapse of a predetermined period in the future. Further, if the degradation value after the lapse of the predetermined period is calculated based on the estimated SOH, the SOH after the lapse of the predetermined period can be further estimated. By repeating the estimation of SOH every predetermined period, it is also possible to estimate whether or not the energy storage device reaches the end of its life (whether or not SOH is EOL or less) at the expected life of the energy storage device (for example, 10 years, 15 years, etc.).

The energy storage device evaluation device includes a parameter acquisition unit that acquires the design parameters of the energy storage device, and the evaluation unit can evaluate the state of the energy storage device according to the design parameters acquired by the parameter acquisition unit.

The parameter acquisition unit acquires the design parameters of the energy storage device. The evaluation unit evaluates the state of the energy storage device according to the design parameters acquired by the parameter acquisition unit. The design parameters of the energy storage device include various parameters necessary for the system design such as the type, number, and rating of the energy storage device prior to the actual operation of the system. By evaluating the state of the energy storage device according to the design parameters, for example, it is possible to understand what design parameters should be adopted to obtain the optimum operation method for the entire system in consideration of the degradation of the energy storage device.

The energy storage device evaluation device can include an output unit that outputs a command of an action including a change in the load state of the energy storage device based on the evaluation result of the state of the energy storage device by the evaluation unit.

The output unit outputs a command of an action including a change in the load state of the energy storage device based on the evaluation result of the state of the energy storage device by the evaluation unit. As a result, an action including a change in the load state is obtained by reinforcement learning with respect to the state of the energy storage device, and by changing the load state of the energy storage device based on the command, it is possible to optimally distribute the load of the energy storage device in consideration of the degradation of the energy storage device, and to reduce the cost as a whole.

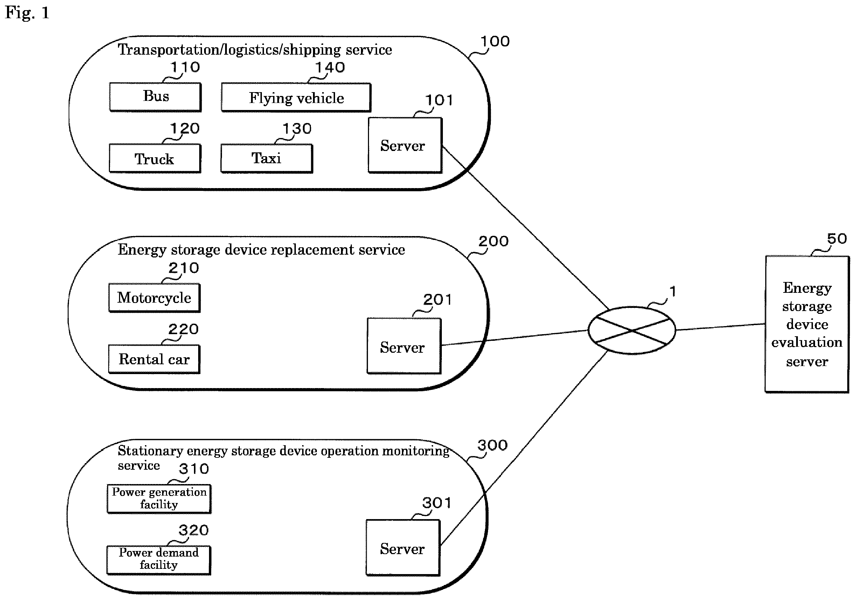

Hereinafter, the energy storage device evaluation device, the computer program, the energy storage device evaluation method, and the learning method according to the present embodiment will be described with reference to the drawings. Fig. 1 is a schematic diagram showing an example of the configuration of the energy storage device evaluation system. The energy storage device evaluation system includes an energy storage device evaluation server 50 as an energy storage device evaluation device, and evaluates the state of the energy storage device. The energy storage device may include an energy storage device mounted on a bus 110, a truck 120, a taxi 130, a flying vehicle 140, etc. as a moving object provided for a transportation/logistics/shipping service 100, an energy storage device mounted on a motorcycle 210, a rental car 220, etc. as a moving object that is a target of an energy storage device replacement service 200, and an energy storage device used in a power generation facility 310 or a power demand facility 320 that is a target of a stationary energy storage device operation monitoring service 300. The bus 110, the truck 120, the taxi 130, the flying vehicle 140, the motorcycle 210, the rental car 220, the power generation facility 310, the power demand facility 320, and servers 101, 201, and 301 are provided with communication functions for performing communication. In the present embodiment, the bus 110, the truck 120, the taxi 130, the flying vehicle 140, the motorcycle 210, and the rental car 220 are electric vehicles (EV) or hybrid electric vehicles (HEV), and are mounted with an energy storage device for driving. The size of the energy storage device mounted on the electric vehicle provided for the transportation/logistics/shipping service 100 is relatively large. The size of the energy storage device mounted on the electric vehicle that is the target of the energy storage device replacement service 200 is relatively small and can be a target of replacement. Although Fig. 1 shows one bus 110, one truck 120, one taxi 130, one motorcycle 210, one rental car 220, one power generation facility 310, and one power demand facility 320, each of them may exist in plural number. The energy storage device is preferably a rechargeable device such as a secondary battery such as a lead-acid battery or a lithium ion battery, or a capacitor.

The energy storage device evaluation server 50 is connected to a communication network 1 such as the Internet. The servers 101, 201, and 301 are connected to the communication network 1. The server 101 is provided for the transportation/logistics/shipping service 100, collects the state (for example, voltage, current, power, temperature, state of charge (SOC)) of the energy storage device mounted on the bus 110, the truck 120, the taxi 130, or the flying vehicle 140, and transmits the collected state to the energy storage device evaluation server 50. The server 201 collects the state (for example, voltage, current, power, temperature, state of charge (SOC)) of the energy storage device mounted on the motorcycle 210 or the rental car 220, which is a target of the energy storage device replacement service 200, and transmits the collected state to the energy storage device evaluation server 50. The server 301 collects the state (for example, voltage, current, power, temperature, state of charge (SOC)) of the energy storage device used in the power generation facility 310 or the power demand facility 320, which is a target of the stationary energy storage device operation monitoring service 300, and transmits the collected state to the energy storage device evaluation server 50. In the example of Fig. 1, one server 101, one server 201, and one server 301 are shown, but each of them may be provided in plural number. The state of the energy storage device may be directly transmitted to the energy storage device evaluation server 50 without going through the server 101, 201, 301.

Details of the transportation/logistics/shipping service 100, the energy storage device replacement service 200, and the stationary energy storage device operation monitoring service 300 will be described later.

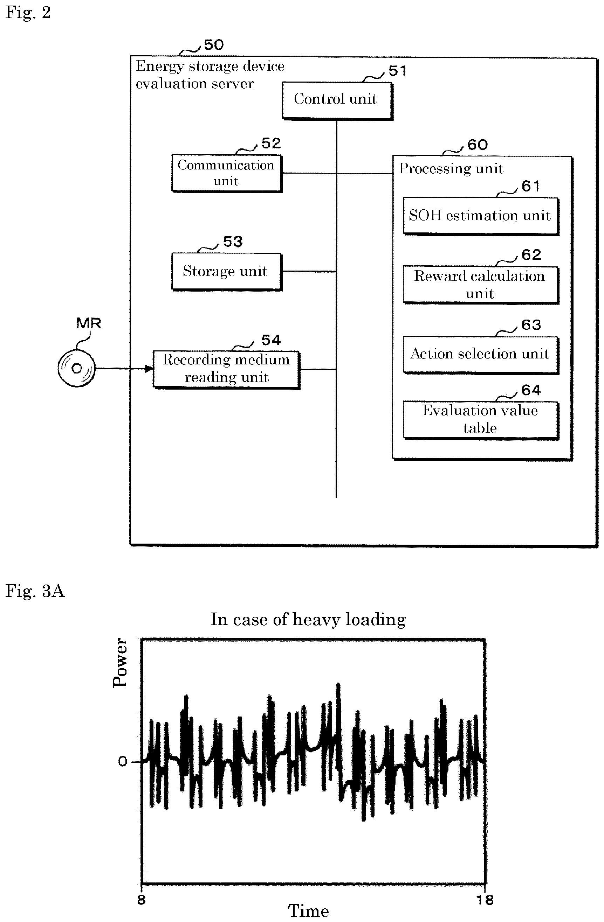

Fig. 2 is a block diagram showing an example of the configuration of the energy storage device evaluation server 50. The energy storage device evaluation server 50 includes a control unit 51 that control the entire server, a communication unit 52, a storage unit 53, a recording medium reading unit 54, and a processing unit 60. The processing unit 60 includes an SOH estimation unit 61, a reward calculation unit 62, an action selection unit 63, and an evaluation value table 64. A calculation-based life prediction simulator may be used as the SOH estimation unit 61.

The control unit 51 can be configured by, for example, a CPU, and controls the entire server by using a built-in memory such as ROM and RAM. The control unit 51 executes information processing based on a server program stored in the storage unit 53.

The communication unit 52 transmits/receives data to/from the servers 101, 201, and 301 via the communication network 1. Further, the communication unit 52 transmits/receives data to/from the electric vehicle via the communication network 1.

Under the control of the control unit 51, the communication unit 52 receives (acquires) data such as the state (for example, voltage, current, power, temperature, SOC, etc.) of the energy storage device mounted on the electric vehicle and stores the received data in the storage unit 53.

Further, the communication unit 52 receives (acquires) the state (for example, voltage, current, power, temperature, SOC) of the energy storage device used in the power generation facility 310 and the power demand facility 320 of the stationary energy storage device operation monitoring service 300 via the server 301, and stores the received data in the storage unit 53.

The storage unit 53 can use a non-volatile memory such as a hard disk or a flash memory. The storage unit 53 can store the data received by the communication unit 52.

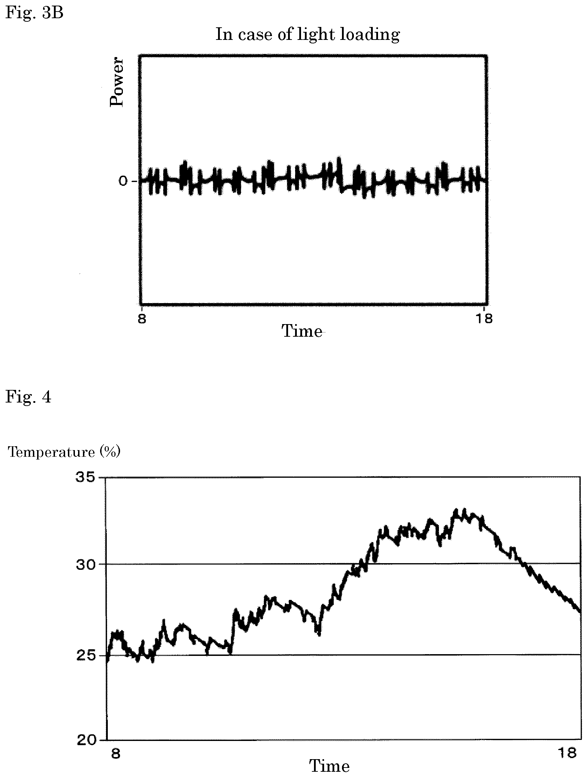

Figs. 3A and 3B are schematic views showing an example of the load power of the energy storage device. In the figure, the vertical axis represents power, and with zero as a reference, the positive side represents the power at the time of charging, and the negative side represents the power at the time of discharging. The horizontal axis represents time. Although the time from 8:00 am to 18:00 pm is shown, the time width on the horizontal axis is not limited to the example in the figure, and for example, one day from 0:00 to 24:00 may be used, or one week, one month, spring/summer/autumn/winter, one year, etc. may be used.

Fig. 3A shows a case where the load is a heavy loading, and Fig. 3B shows a case where the load is a light loading. It can be seen that in the case of the heavy loading, the average value of the power, the fluctuation range of the power, and the peak value are larger than those in the case of the light loading. Therefore, it is considered that the heavy loading has a greater influence on the degradation of the energy storage device than the light loading. The power shown in Figs. 3A and 3B is an example, and the load power of the energy storage device mounted on the electric vehicle and the energy storage device used in the power generation facility 310 or the power demand facility 320 differs depending on the usage situation.

The storage unit 53 can separately store information on the load power of the energy storage device mounted on the electric vehicle and the energy storage device used in the power generation facility 310 or the power demand facility 320 for each energy storage device.

Fig. 4 is a schematic diagram showing an example of the environmental temperature of the energy storage device. In Fig. 4, the vertical axis represents temperature and the horizontal axis represents time. Although the time from 8:00 am to 18:00 pm is shown, the time width on the horizontal axis is not limited to the example in the figure, and for example, one day from 0:00 to 24:00 may be used, or one week, one month, spring/summer/autumn/winter, one year, etc. may be used. The environmental temperature shown in Fig. 4 is an example, and the load power of the energy storage device mounted on the electric vehicle and the energy storage device used in the power generation facility 310 or the power demand facility 320 differs depending on the usage situation.

The storage unit 53 can separately store information on the environmental temperature of the energy storage device mounted on the electric vehicle and the energy storage device used in the power generation facility 310 or the power demand facility 320 for each energy storage device.

Next, the processing unit 60 will be described.

In the processing unit 60, the reward calculation unit 62, the action selection unit 63, and the evaluation value table 64 constitute a function for performing reinforcement learning. The processing unit 60 is subjected to reinforcement learning using the degradation value (which can be replaced with the SOH (State Of Health) of the energy storage device) of the energy storage device output by the SOH estimation unit 61, thereby obtaining the optimal operating conditions that reach expected life (for example, 10 years, 15 years, etc.) of the energy storage device. The details of the processing unit 60 will be described below.

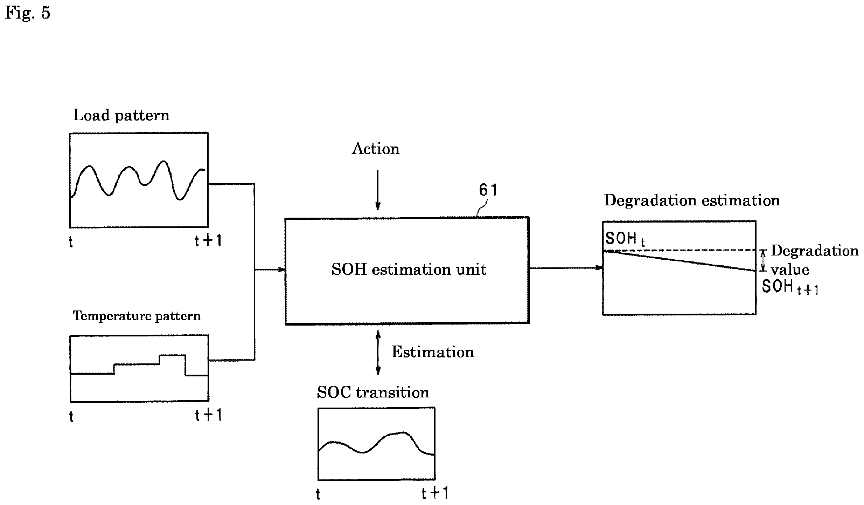

Fig. 5 is a schematic diagram showing the operation of the SOH estimation unit 61. The SOH estimation unit 61 may be a life prediction simulator that estimates SOH on a calculation basis from a history such as sensor data, or the one that estimates SOH on an actual measurement basis using short-term sensor data. The SOH estimation unit 61 acquires the load pattern (for example, the load power information of Fig. 3) and the temperature pattern (for example, the environmental temperature information of Fig. 4) of each of the plurality of energy storage devices as input data. The SOH estimation unit 61 estimates the SOC transition of the energy storage device, and also estimates (calculates) the degradation value of the energy storage device. Further, the SOH estimation unit 61 acquires the action selected by the action selection unit 63, estimates the SOC transition of the energy storage device, and also estimates the degradation value of the energy storage device. The SOC transition can be calculated, for example, by integrating the charge/discharge current flowing through the energy storage device.

Assuming that the SOH (also called the degree of health) at the time point t is $SOH_t$ and the SOH at the time point t + 1 is $SOH_{t+1}$, the degradation value is $(SOH_t - SOH_{t+1})$. Here, the time point can be a time point of the present or the future, and the time point t + 1 can be a time point at which the required time has elapsed from the time point t toward the future. The time difference between the time point t and the time point t + 1 is the life prediction target period of the SOH estimation unit 61, and can be appropriately set according to how much future the life is predicted. The time difference between the time point t and the time point t + 1 can be, for example, the required time such as one month, half a year, one year, or two years.

When the period from the start point to the end point of the load pattern or temperature pattern is shorter than the life prediction target period of the SOH estimation unit 61, for example, the load pattern or temperature pattern can be repeatedly used over the life prediction target period.

The SOH estimation unit 61 has a function as an SOC transition estimation unit, and estimates the SOC transition of the energy storage device based on the load pattern and the action selected by the action selection unit 63. The SOC increases when the energy storage device is charged during the life prediction target period. On the other hand, when the energy storage device is discharged, the SOC decreases. During the life prediction target period, the energy storage device may not be charged or discharged (for example, at night). The SOH estimation unit 61 estimates the SOC transition over the life prediction target period. Depending on a battery management device (not shown) in the electric vehicle, in the power generation facility 310 or in the power demand facility 320, the SOC fluctuation can be limited by the upper and lower limits of the SOC.

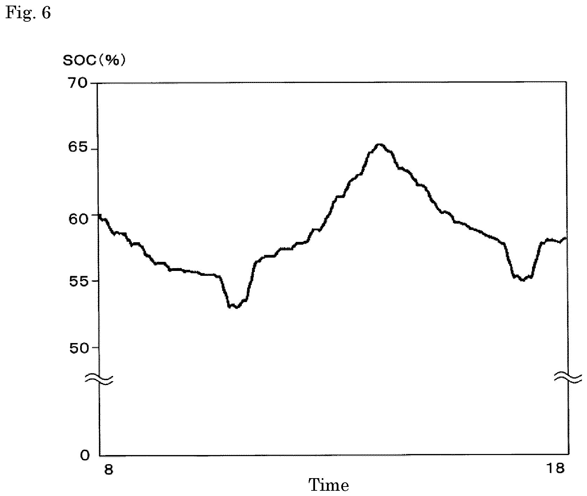

Fig. 6 is a schematic diagram showing an example of the SOC transition of the energy storage device. In Fig. 6, the vertical axis represents SOC and the horizontal axis represents time. Although the time from 8:00 am to 18:00 pm is shown, the time width on the horizontal axis is not limited to the example in the figure, and for example, one day from 0:00 to 24:00 may be used, or one week, one month, spring/summer/autumn/winter, one year, etc. may be used. The SOC shown in Fig. 6 is an example, and actually differs for each energy storage device. The load power of the energy storage device mounted on the electric vehicle and the energy storage device used in the power generation facility 310 or the power demand facility 320 differs depending on the usage situation.

The SOH estimation unit 61 can estimate the temperature of the energy storage device based on the environmental temperature of the energy storage device.

The SOH estimation unit 61 has a function as an SOH estimation unit, and estimates the SOH of the energy storage device based on the estimated SOC transition and the temperature of the energy storage device. The degradation value Qdeg after the lapse of the life prediction target period (for example, from the time point t to the time point t + 1) of the energy storage device can be calculated by the formula Qdeg = Qcnd + Qcur.

Here, Qcnd is a non-energization degradation value, and Qcur is an energization degradation value. The non-energization degradation value Qcnd can be obtained by, for example, $Qcnd = K1 \times \sqrt{(t)}$. Here, the coefficient K1 is a function of SOC and temperature T. t is the elapsed time, for example, the time from time point t to time point t + 1. The energization degradation value Qcur can be obtained by, for example, $Qcur = K2 \times$ (SOC fluctuation amount). Here, the coefficient K2 is a function of SOC and temperature T. Assuming that the SOH at the time point t is $SOH_t$ and the SOH at the time point t + is $SOH_{t+1}$, the SOH can be estimated by $SOH_{t+1} = SOH_t - Qdeg$.

The coefficient K1 is a degradation coefficient, and the correspondence between the SOC and the temperature T and the coefficient K1 may be obtained by calculation, or can be stored in a table format. The number K2 is also the same with the coefficient K1.

As described above, the SOH estimation unit 61 can estimate the SOH after the lapse of the future life prediction target period. If the degradation value after the lapse of the life prediction target period is further calculated based on the estimated SOH, the SOH after the lapse of the life prediction target period can be further estimated. By repeating the estimation of SOH every time the life prediction target period elapses, it is also possible to estimate whether or not the energy storage device reaches the end of its life at the expected life (for example, 10 years, 15 years, etc.) of the energy storage device (whether or not SOH is EOL or less).

In the reinforcement learning in the present embodiment, as an action, the optimum operation method is learned as to how the load state of the energy storage device is to be changed (how the load of a plurality of energy storage devices is to be distributed) to prevent premature degradation of a specific energy storage device, and to suppress the decrease in the average SOH of the energy storage devices of the entire system or to reduce the operation cost. The details of reinforcement learning will be described below.

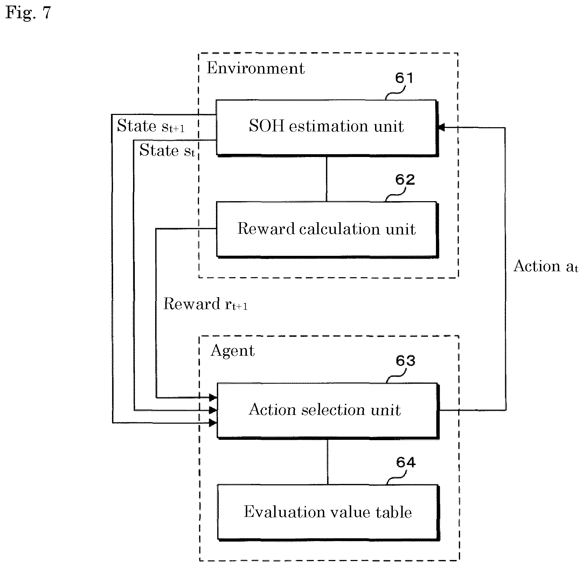

Fig. 7 is a schematic diagram showing an example of reinforcement learning of the present embodiment. Reinforcement learning is a machine learning algorithm that seeks measures (rules that are indicators when an agent acts) so that the agent placed in a certain environment acts on the environment to obtain maximum reward. In reinforcement learning, an agent is like a learner who takes action on the environment and is a learning target. The environment updates the state and imparts the reward with respect to the agent's action. The action is an action that an agent can take for a certain state in the environment. The state is a state of the environment held by the environment. The reward is imparted to an agent when the agent has the desired effect on the environment. The reward can be, for example, a positive, negative, or 0 value, and if it is positive, it is the reward itself, if it is negative, it is a penalty, and if it is 0, there is no reward. The action evaluation function is a function that determines the evaluation value of the action in a certain state and can be expressed in a table format like a table, and in Q-learning, it is called a Q function, a Q value, an evaluation value, or the like. Q-learning is one of the methods often used in reinforcement learning. In the following, Q-learning will be described, but reinforcement learning may be different from Q-learning as an alternative.

In the processing unit 60 of the present embodiment, the SOH estimation unit 61 and the reward calculation unit 62 correspond to the environment, and the action selection unit 63 and the evaluation value table 64 correspond to the agent. The evaluation value table 64 corresponds to the above-mentioned Q function, and is also referred to as action evaluation information. Note that the number of agents is not limited to one, and a plurality of agents can be also used. This makes it possible to search for the optimum system operation method even in a large-scale and complicated environment (service environment).

Based on the evaluation value table 64, the action selection unit 63 selects an action including a change in the load state of the energy storage device with respect to the state including the SOH (State Of Health) of the energy storage device. The load state of the energy storage device includes physical quantities such as current, voltage, and power when the energy storage device is charged or discharged. The temperature of the energy storage device can also be included in the load state. Changes in the load state include change patterns such as current, voltage, power or temperature (including fluctuation range, average value, peak value, etc.), change in the location where the energy storage device is used, change in the use state (for example, change between use state and stored state), and so on. Considering that each of the plurality of energy storage devices has an individual load state, changing the load state of the energy storage device corresponds to load distribution.

In the example of Fig. 7, the action selection unit 63 acquires the state $s_t$ (for example, $SOH_t$) at the time point t from the SOH estimation unit 61, selects the action at, and outputs it. The action selection unit 63 can select the action with the highest evaluation (for example, Q value is the largest) in the evaluation value table 64. The details of the action will be described later.

The action selection unit 63 has a function as a state acquisition unit, and acquires the state (SOH) of the energy storage device when the selected action is executed. When the load power information of the energy storage device is given to the SOH estimation unit 61 based on the action selected by the action selection unit 63, the SOH estimation unit 61 outputs the state $s_{t+1}$ at the time point t + 1 (for example, $SOH_{t+1}$), and the state is updated from $s_t$ to $s_{t+1}$. The action selection unit 63 acquires the updated state. The action selection unit 63 has a function as a reward acquisition unit, and acquires the reward calculated by the reward calculation unit 62.

The reward calculation unit 62 calculates the reward when the selected action is executed. A high value (positive value) is calculated when the action selection unit 63 acts on the SOH estimation unit 61 with a desired result. When the reward is zero, there is no reward, and when the reward is negative, there is a penalty. In the example of Fig. 7, the reward calculation unit 62 imparts the reward $r_{t+1}$ to the action selection unit 63. The details of the reward calculation will be described later.

The action selection unit 63 has a function as an update unit, and updates the evaluation value table 64 based on the acquired state $s_{t+1}$ and reward $r_{t+1}$. More specifically, the action selection unit 63 updates the evaluation value table 64 in the direction of maximizing the reward for the action. This makes it possible to learn the action that is expected to have the maximum value in a certain state of the environment.

By repeating the above processing to repeat update of the evaluation value table 64, it is possible to learn the evaluation value table 64 that can maximize the reward.

The processing unit 60 has a function as an evaluation unit, and based on the updated evaluation value table 64 (that is, a learned evaluation value table 27), can execute an action including a change in the load state of the energy storage device to evaluate the state including the SOH of the energy storage device. As a result, the action including a change in the load state is obtained by reinforcement learning with respect to the state including the SOH of the energy storage device, and the SOH of the energy storage device can be evaluated as a result of the action including the change in the load state. By evaluating each of the plurality of energy storage devices, the load of the energy storage devices can be optimally distributed in consideration of the degradation of the energy storage devices, and the cost can be reduced as a whole.

The Q function in Q-learning can be updated by Equation (1).

[Math. 1]

$$Q(s_t, a_t) \leftarrow Q(s_t, a_t) + \alpha \left\{ r_{t+1} + \gamma \cdot \max Q(s_{t+1}, a_{t+1}) - Q(s_t, a_t) \right\} \quad \cdots (1)$$

$$Q(s_t, a_t) \leftarrow Q(s_t, a_t) + \alpha \left\{ r_{t+1} - Q(s_t, a_t) \right\} \quad \cdots (2)$$

$$Q(s_t, a_t) \leftarrow Q(s_t, a_t) + \alpha \left\{ \gamma \cdot \max Q(s_{t+1}, a_{t+1}) - Q(s_t, a_t) \right\} \quad \cdots (3)$$

Here, Q is a function or table (for example, evaluation value table 64) that stores the evaluation of the action a in the state s, and can be represented in a matrix format with each state s as row and each action a as column.

In Equation (1), st indicates the state at the time point t, $a_t$ indicates the action that can be taken in the state $s_t$, $\alpha$ indicates the learning rate (where $0 < \alpha < 1$), and $\gamma$ indicates the discount rate (where $0 < \gamma < 1$). The learning rate $\alpha$ is also called a learning coefficient and is a parameter that determines the learning speed (step size). That is, the learning rate $\alpha$ is a parameter for adjusting the update amount of the evaluation value table 64. The discount rate $\gamma$ is a parameter that determines how much the evaluation (reward or penalty) of the future state is discounted and considered when updating the evaluation value table 64. That is, it is a parameter that determines how much the reward or penalty is discounted when the evaluation in a certain state is connected to the evaluation in the past state.

In Equation (1), $r_{t+1}$ is the reward obtained as a result of the action, and if no reward is obtained, it becomes 0, and if it is a penalty, it becomes a negative value. In Q-learning, the evaluation value table 64 is updated so that the second term of Equation (1), $\{r_{t+1} + \gamma \cdot \max Q (s_{t+1}, a_{t+1}) - Q (s_t, a_t)\}$ becomes 0, that is, the value $Q (s_t, a_t)$ of the evaluation value table 64 is the sum of the reward ($r_{t+1}$) and the maximum value ($\gamma \cdot \max Q (s_{t+1}, a_{t+1})$) among the actions possible in the next state $s_{t+1}$. The evaluation value table 64 is updated so that the error between the expected value of the reward and the current action evaluation approaches 0. In other words, the value of ($\gamma \cdot \max Q (s_{t+1}, a_{t+1})$) is modified based on the current value of $Q (s_t, a_t)$ and the maximum evaluation value obtained in the action executable in the state st+i after executing the action at.

When an action is executed in a certain state, a reward is not always obtained. For example, the reward may be obtained after repeating the action several times. Equation (2) expresses the update equation of the Q function when the reward is obtained, and Equation (3) expresses the update equation of the Q function when the reward is not obtained.

In the initial state of Q-learning, the Q value in the evaluation value table 64 can be initialized with, for example, a random number. Once there is a difference in the expected value of reward in the initial stage of Q-learning, it may not be possible to transition to a state that has not been experienced yet, and a situation may occur in which the goal cannot be reached. Therefore, the probability $\varepsilon$ can be used to determine the action for a certain state. Specifically, it is possible to randomly select an action from among all actions and execute it with a certain probability $\varepsilon$, and select an action with the maximum Q value and execute it with a probability ($1-\varepsilon$). This makes it possible to allow learning to appropriately proceed regardless of the initial state of the Q value.

Next, reinforcement learning and evaluation of energy storage devices will be described for each of the transportation/logistics/shipping service 100, the energy storage device replacement service 200, and the stationary energy storage device operation monitoring service 300. First, the transportation/logistics/shipping service 100 will be described.

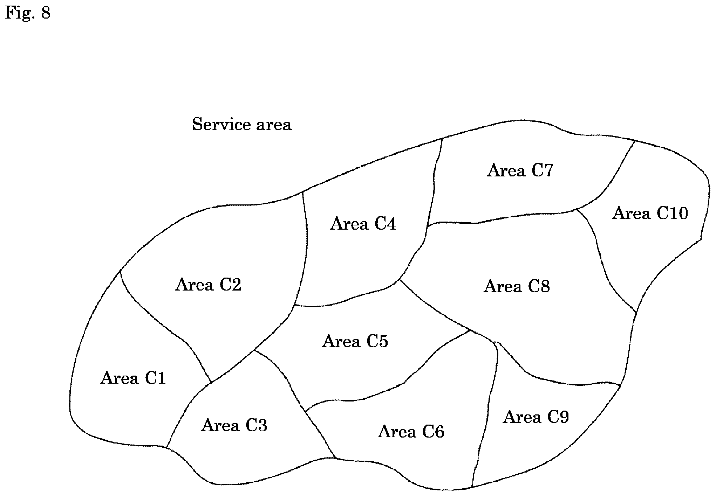

Fig. 8 is a schematic diagram showing an example of a service area of the transportation/logistics/shipping service 100. The service area means an area where logistics and shipping services are provided using electric vehicles. In the example of Fig. 8, the road network is divided into 10 areas (moving areas) C1,..., C10, but instead, may be divided into n areas C1, C2,..., Cn.

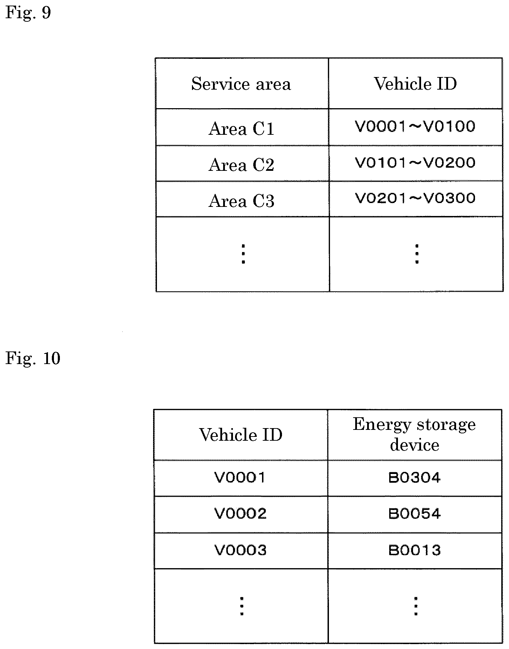

Fig. 9 is a schematic diagram showing an example of the allocation state of the electric vehicle for each region. As shown in Fig. 9, electric vehicles with vehicle IDs V0001 to V0100 are allocated to the area C1. That is, the electric vehicles with vehicle IDs V0001 to V0100 are used for logistics/shipping services within the area C1. Similarly, electric vehicles with vehicle IDs V0101 to V0200 are allocated to the area C2. That is, the electric vehicles with vehicle IDs V0101 to V0200 are used for logistics/shipping services within the area C2. The same is true for other areas. That is, the electric vehicle mounted with the energy storage device is moved within one of the plurality of areas into which the road network is divided.

Fig. 10 is a schematic diagram showing the relationship between an electric vehicle and an energy storage device mounted on the electric vehicle. As shown in Fig. 10, the vehicle ID and the energy storage device ID that identifies the energy storage device are associated with each other. As shown in Fig. 8, when the road network is divided into a plurality of areas, in some specific areas, it is considered that their environments are different from those in the other areas, such as many slopes, many intersections with traffic lights, and many highways, and it is considered that the load state of the energy storage device mounted on the electric vehicle is also different. By preparing the relationship as shown in Fig. 10 in advance, it is possible to grasp in which area each energy storage device is used. The information shown in Figs. 9 and 10 can be stored in the storage unit 53.

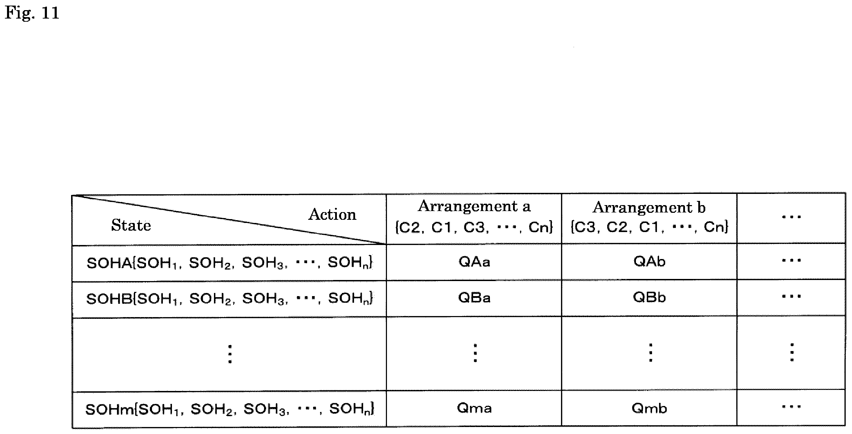

Fig. 11 is a schematic diagram showing an example of the configuration of the evaluation value table 64. The evaluation value table 64 is expressed in a matrix format composed of each state of the energy storage device and each action, and each element in the matrix format stores the evaluation value when the action is taken in each state. The states can be expressed as SOHA $\{SOH_1, SOH_2, SOH_3,..., SOH_n\}$, SOHB $\{SOH_1, SOH2, SOH_3,..., SOH_n\}$,..., SOHm $\{SOH_1, SOH2, SOH_3,..., SOH_n\}$. Here, $SOH_1$ is the SOH of the energy storage device that was arranged in the area C1 before the action, $SOH_2$ is the SOH of the energy storage device that was arranged in the area C2 before the action, and similarly, $SOH_n$ is the SOH of the energy storage device that was arranged in the area Cn before the action. That is, the state is the SOH of all the energy storage devices at each arrangement location. In SOHA and SOHB, the SOH of the energy storage devices arranged in each location is different. For example, $SOH_1$ of SOHA $\{SOH_1, SOH_2, SOH_3,...,$

$SOH_n$} is different from $SOH_1$ of SOHB {$SOH_1$, $SOH_2$, $SOH_3$,..., $SOH_n$}. Note that, in SOHA and SOHB, a part of {$SOH_1$, $SOH_2$, $SOH_3$,..., $SOH_n$} may be the same SOH.

Actions can be expressed as arrangement a {C2, C1, C3,..., Cn}, arrangement b {C3, C2, C1,..., Cn},.... Since the arrangement before the action is {C1, C2, C3,..., Cn}, the arrangement a means that the energy storage device arranged in the area C1 is arranged in the area C2 and the energy storage device arranged in the area C2 is arranged in the area C1. Further, the arrangement b means that the energy storage device arranged in the area C1 is arranged in the area C3, and the energy storage device arranged in the area C3 is arranged in the area C1. The action means changing (switching) the combination of the load (arrangement) and the energy storage device of each SOH. The action is to switch areas (change the arrangement pattern) in the transportation/logistics/shipping service 100. As will be described later, the action is to switch the stored state (change the arrangement pattern) in the energy storage device replacement service 200, and to switch to another different load (change the arrangement pattern) in the stationary energy storage device operation monitoring service 300.

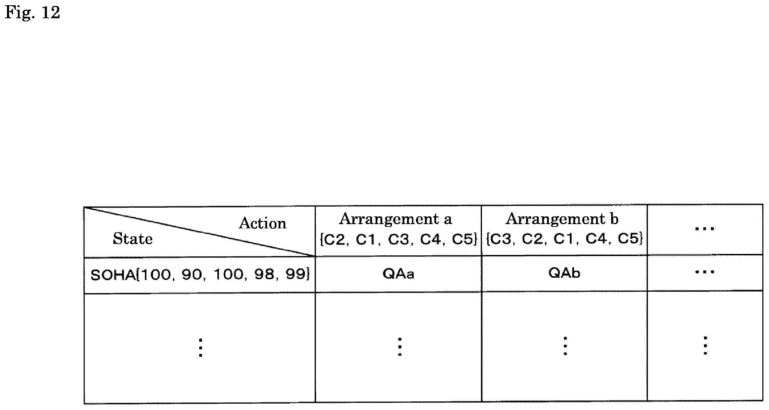

Fig. 12 is a schematic diagram showing an example of the evaluation values in the evaluation value table 64. In the example of Fig. 12, the areas are assumed to be C1, C2, C3, C4, and C5. The state SOHA before action is assumed to be SOHA {100, 90, 100, 98, 99}. That is, the SOHs of the energy storage devices arranged in the areas C1, C2, C3, C4, and C5 before the action are 100, 90, 100, 98, and 99, respectively. When the load is light in the area C1 and the load is heavy in the area C2, the SOH (90) of the energy storage device in the area C2 is lower than the SOHs of other energy storage devices, as in the state SOHA, without switching the area.

In the state SOHA, when the action of arrangement a is selected, the energy storage device arranged in C1 is arranged in the area C2, the energy storage device arranged in the area C2 is arranged in the area C1, thus the combination of SOH of the energy storage devices after the action is {90, 100, 100, 98, 99}, the energy storage device having a high SOH is arranged in the area C2 where the load is heavy, and therefore the SOH of the energy storage devices as a whole is maintained high.

In the state SOHA, when the action of arrangement b is selected, the energy storage device arranged in C1 is arranged in the area C3, the energy storage device arranged in the area C3 is arranged in the area C1, thus the combination of SOH of the energy storage devices after the action is {100, 90, 100, 98, 99}, the energy storage device with low SOH remains arranged in the area C2 where the load is heavy, and therefore the SOH of the energy storage devices as a whole cannot be maintained high. Therefore, the evaluation value QAa is higher than QAb when only the reward for the SOH of the energy storage devices as a whole at this time point is considered.

In Q-learning, the evaluation value table 64 (also called the Q table) of the size of (number of states s x number of actions a) can be updated, but instead, a method of expressing the Q function with a neural network can be adopted.

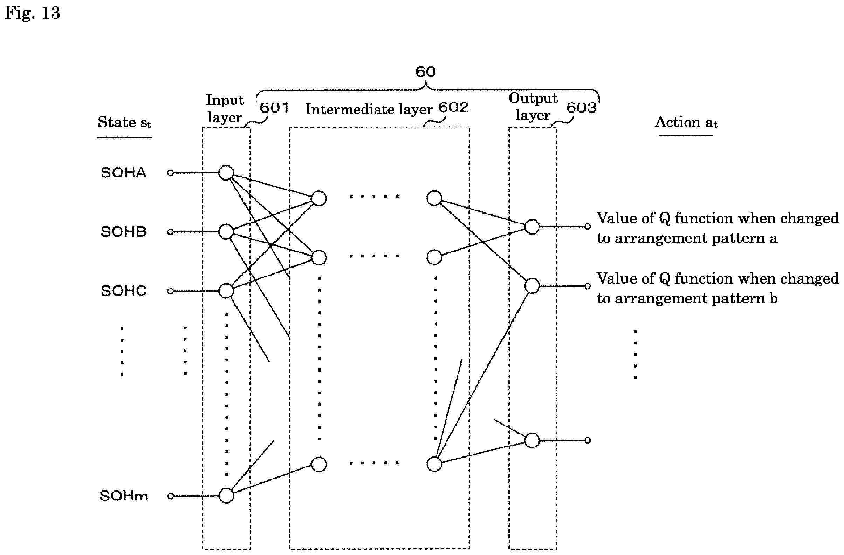

Fig. 13 is a schematic diagram showing an example of the configuration of a neural network model of the present embodiment. The neural network model represents the processing unit 60. The example shown in Fig. 13 corresponds to the evaluation value table 64 shown in Fig. 11. The neural network model has an input layer 601, an intermediate layer 602, and an output layer 603. The number of input neurons in the input layer 601 can be the number of states of the energy storage devices (for example, m in the case of SOHA, SOHB,..., SOHm), and the states of the energy storage devices (for example, SOHA, SOHB,..., SOHm) are input to the input neurons in the input layer 601.

The number of output neurons in the output layer 603 can be the number of options of the action. In Fig. 13, the output neurons output the value of the Q function when the pattern is changed to the arrangement pattern a, the value of the Q function when the pattern is changed to the arrangement pattern b,....,.

Machine learning (deep reinforcement learning) using a neural network model can be performed as follows. That is, when the state $s_t$ is input to the input neuron of the neural network model, the output neuron outputs $Q(s_t, a_t)$. Here, Q is a function that stores the evaluation of the action a in the state s. The Q function can be updated by the above Equation (1).

In Equation (1), $r_{t+1}$ is the reward obtained as a result of the action, and if no reward is obtained, it becomes 0, and if it is a penalty, it becomes a negative value. In Q-learning, the parameters of the neural network model are learned so that the second term of Equation (1), {$r_{t+1} + \Upsilon \cdot maxQ(s_{t+1}, a_{t+1}) - Q(s_t, a_t)$} becomes 0, that is, the Q function $Q(s_t, a_t)$ is the sum of the reward ($r_{t+1}$) and the maximum value ($\gamma \cdot maxQ(s_{t+i}, a_{t+1})$) among the actions possible in the next state $s_{t+1}$. The parameters of the neural network model are updated so that the error between the expected value of the reward and the current action evaluation approaches zero. In other words, the value of ($\gamma \cdot maxQ(s_{t+1}, a_{t+1})$) is modified based on the current value of $Q(s_t, a_t)$ and the maximum evaluation value obtained in the action executable in the state $s_{t+1}$ after executing the action at.

When an action is executed in a certain state, a reward is not always obtained. For example, the reward may be obtained after repeating the action several times. Equation (2) represents the update equation of the Q function when the reward is obtained by avoiding the problem of divergence in Equation (1). Equation (3) represents the update equation of the Q function when no reward is obtained in Equation (1).

Whether to use the evaluation value table 64 as shown in Fig. 11 or the neural network model as shown in Fig. 13 can be appropriately determined.

In the reinforcement learning and energy storage device evaluation in the transportation/logistics/shipping service 100, the action includes switching from an area where the electric vehicle moves to another area different from the area. The action also includes the case of not switching the area.

The control unit 51 has a function as an output unit, and outputs a command of an action including a change in the load state of the energy storage device based on the evaluation result of the state including SOH of the energy storage device. In this case, the command may be output to the server 101 or may be output to each electric vehicle. Specifically, the command includes an instruction to switch from the current area to which area the electric vehicle mounted with the energy storage device moves. As a result, the action including a change in the load state with respect to the state including the SOH of the energy storage device can be obtained by reinforcement learning, and by changing the load state of the energy storage device based on the command, it is possible to optimally distribute the load of the energy storage devices in consideration of the degradation of the energy storage devices and to reduce the cost as a whole.

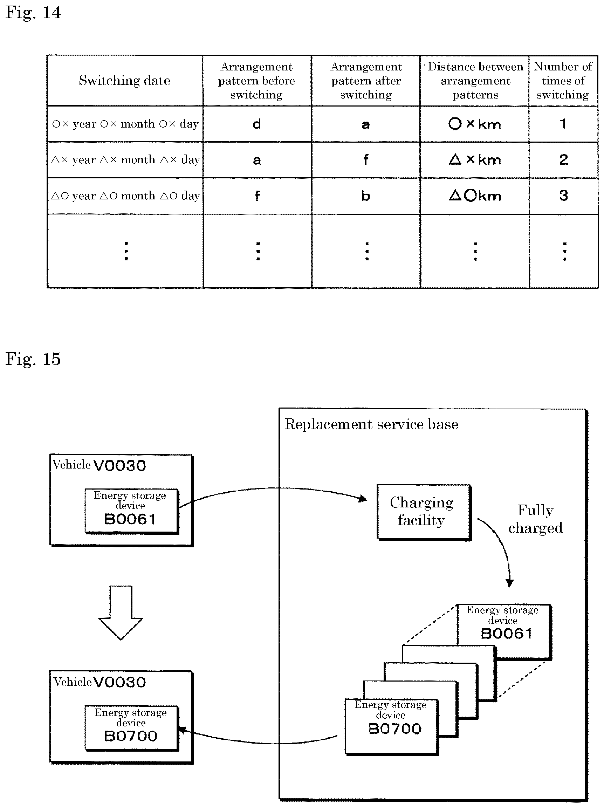

Fig. 14 is a schematic diagram showing an example of switching areas where the electric vehicles are allocated. Fig. 14 shows a change in the load state of a certain electric vehicle, that is, an energy storage device mounted on the electric vehicle, based on a command output by the control unit 51. As shown in Fig. 14, the switching information includes information such as the switching date, the arrangement pattern before switching, the arrangement pattern after switching, the distance between arrangement patterns, and the number of times of switching for each energy storage device (electric vehicle). The distance between the arrangement patterns is the moving distance between the arrangement pattern before switching and the arrangement pattern after switching, and the reference point in the area for calculating the distance can be appropriately determined in consideration of the road network. For example, the intersection with the heaviest traffic may be used as a reference.

In this case, the reward calculation unit 62 has a function as a first reward calculation unit, and can calculate a reward based on the moving distance between areas due to the switching of the arrangement patterns. For example, it is considered that the longer the moving distance, the higher the cost due to changing the allocation of electric vehicles and switching areas tends to become, so the calculation can be made so that the longer the moving distance, the smaller the reward, or the negative reward (penalty). As a result, it is possible to suppress an increase in the cost of the entire system including the plurality of energy storage devices.

Further, the reward calculation unit 62 has a function as a second reward calculation unit, and can calculate a reward based on the number of times of switching. For example, if priority is given to the operation of maintaining a high average SOH of the energy storage devices in the entire system including a plurality of energy storage devices, the calculation can be made so that the reward is not small or negative (penalty) even if the number of times of switching is large, at the expense of a slight cost increase due to the increase in the number of times of switching. On the other hand, if priority is given to the operation of reducing the switching cost for the entire system including a plurality of energy storage devices, the calculation can be made so that the reward is a relatively large value as the number of times of switching is smaller, at the expense of a slight decrease in the average SOH of the energy storage devices due to the reduction in the number of times of switching. As a result, optimum operation can be realized.

The action selection unit 63 updates the evaluation value table 64 as shown in Fig. 11 based on the acquired state $s_{t+1}$ and reward $r_{t+1}$. More specifically, the action selection unit 63 updates the evaluation value table 64 in the direction of maximizing the reward for the action. This makes it possible to learn the action that is expected to have the maximum value in a certain state of the environment.

By repeating the above processing to repeat update of the evaluation value table 64, it is possible to learn the evaluation value table 64 that can maximize the reward.

Based on the updated evaluation value table 64 (that is, the learned evaluation value table 27), the processing unit 60 can execute an action including a change in the load state of the energy storage device to evaluate the state including SOH of the energy storage device. When an electric vehicle allocated to a certain area is moved within that area, the weight of the load on the energy storage device differs for each area, and there is a possibility that the energy storage device of the electric vehicle in a specific area degrades faster.

By learning the switching of area where the electric vehicle moves by reinforcement learning, it is possible to evaluate the SOH of the energy storage device as a result of the area switching (change of the arrangement pattern). By evaluating each of the plurality of energy storage devices, the load of the energy storage devices can be optimally distributed in consideration of the degradation of the energy storage devices, and the cost can be reduced as a whole.

Next, the energy storage device replacement service 200 will be described.

Fig. 15 is a schematic diagram showing an example of the service content of the energy storage device replacement service 200. At a replacement service base, a charging facility for the energy storage device is provided, and the energy storage devices that have been fully charged (for example, SOC = 100%, 95%, etc.) are stored. For example, when a user brings an electric vehicle (V0030) mounted with an energy storage device (B0061) with a reduced SOC to the replacement service base, the user can receive a service to replace the energy storage device (B0061) with a reduced SOC with a fully charged energy storage device (B0700). The energy storage device (B0061) removed from the electric vehicle (V0030) is charged until fully charged by the charging facility and stored. Although not shown, the energy storage device replacement service 200 can also include a service for replacing the energy storage device by using a courier service.

The evaluation value table 64 illustrated in Fig. 11 can be used also in the energy storage device replacement service 200. In the case of the energy storage device replacement service 200, {C1, C2,..., C (n-4)} is set to the mounted state instead of the area {C1, C2, C3,..., Cn}, and {C (n-3), C (n-2), C (n-1), Cn} is set to the stored state, and thereby switching between the mounted state and the stored state can be expressed by the arrangement a, arrangement b,.... Others are the same as the example of Fig. 11, so the description thereof will be omitted.

Instead of the evaluation value table 64, the Q function may be updated using the neural network model illustrated in Fig. 13. In this case, the output neuron outputs the value of the Q function when switched to the mounted state and the value of the Q function when switched to the stored state.

In the reinforcement learning and evaluation of the energy storage device in the energy storage device replacement service 200, the action includes switching between the mounted state in which the energy storage device is mounted on the electric vehicle and the stored state in which the energy storage device is removed from the electric vehicle.

The control unit 51 can output a command of an action including a change in the load state of the energy storage device based on the evaluation result of the state including SOH of the energy storage device.

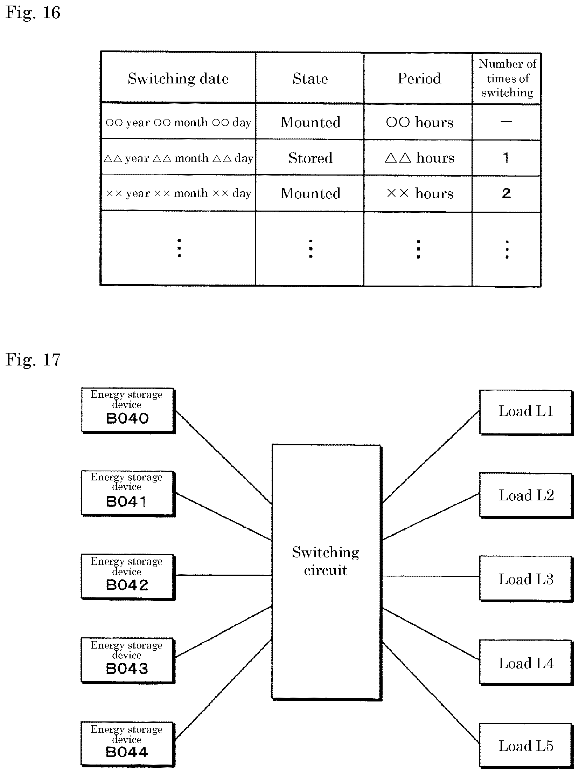

Fig. 16 is a schematic diagram showing an example of replacement of the energy storage device. Fig. 16 shows a change in the load state of the energy storage device mounted on the electric vehicle based on the command output by the control unit 51. As shown in Fig. 16, the replacement information, that is, the switching information between the mounted state and the stored state, includes information such as a switching date, a state, a period, and the number of times of switching for each energy storage device (electric vehicle). The period is a period in the mounted state when the state is "mounted", and a period in the stored state when the state is "stored".

The reward calculation unit 62 can calculate the reward based on the number of times of switching. For example, if priority is given to the operation of maintaining a high average SOH of the energy storage devices in the entire system including a plurality of energy storage devices, the calculation can be made so that the reward is not small or negative (penalty) even if the number of times of switching is large, at the expense of a slight cost increase due to the increase in the number of times of switching. On the other hand, if priority is given to the operation of reducing the switching cost for the entire system including a plurality of energy storage devices, the calculation can be made so that the reward is a relatively large value as the number of times of switching is smaller, at the expense of a slight decrease in the average SOH of the energy storage devices due to the reduction in the number of times of switching. As a result, optimum operation can be realized.

The action selection unit 63 updates the evaluation value table 64 based on the acquired state $s_{t+1}$ and reward $r_{t+1}$. More specifically, the action selection unit 63 updates the evaluation value table 64 in the direction of maximizing the reward for the action. This makes it possible to learn the action that is expected to have the maximum value in a certain state of the environment.

By repeating the above processing to repeat update of the evaluation value table 64, it is possible to learn the evaluation value table 64 that can maximize the reward.

Based on the updated evaluation value table 64 (that is, the learned evaluation value table 27), the processing unit 60 can execute an action including a change in the load state of the energy storage device to evaluate the state including SOH of the energy storage device. The weight of the load state of the energy storage device differs between the mounted state and the stored state.

By learning the switching between the mounted state and the stored state by reinforcement learning, the SOH of the energy storage device can be evaluated as a result of the switching between the mounted state and the stored state. By evaluating each of the plurality of energy storage devices, the load of the energy storage devices can be optimally distributed in consideration of the degradation of the energy storage devices, and the cost can be reduced as a whole.

Next, the stationary energy storage device operation monitoring service 300 will be described.

Fig. 17 is a schematic diagram showing an example of a change in the load state of the energy storage device in the stationary energy storage device operation monitoring service 300. As shown in Fig. 17, a plurality of energy storage devices (B040,..., B044) are connected to a plurality of loads (L1,..., L5) via a switching circuit. For example, it is assumed that the energy storage device (B040) is connected to the load (L1), the energy storage device (B041) is connected to the load (L2), the energy storage device (B042) is connected to the load (L3), the energy storage device (B043) is connected to the load (L4), and the energy storage device (B044) is connected to the load (L5). That is, the energy storage device is connected to one of the plurality of loads. The load (L1,..., L5) is, for example, electrical equipment.

Since the power required for electrical equipment (load) fluctuates depending on the operating state and environmental state, and the power required for the energy storage device also fluctuates, the weight of the load state of the energy storage device differs depending on the individual load connected to the energy storage device. When the loads are fixedly connected to the plurality of energy storage devices, respectively, the weight of the load on the energy storage device differs depending on the load, and the degradation of a specific energy storage device may be accelerated.

The evaluation value table 64 illustrated in Fig. 11 can also be used in the stationary energy storage device operation monitoring service 300. In the case of the stationary energy storage device operation monitoring service 300, instead of the area {C1, C2, C3,..., Cn}, {C1, C2, C3,..., Cn} may be used as loads {L1, L2., L3,..., Ln}, respectively. The load switching can be expressed by the arrangement a, the arrangement b,.... In each state SOHA, SOHB,..., $SOH_1$ is the SOH of the energy storage device connected to the load L1 before the action, $SOH_2$ is the SOH of the energy storage device connected to the load L2 before the action, and similarly, the $SOH_n$ is the SOH of the energy storage device connected to the load Ln before the action. Others are the same as the example of Fig. 11, so the description thereof will be omitted.

Instead of the evaluation value table 64, the Q function may be updated using the neural network model illustrated in Fig. 13. In this case, the output neuron outputs the value of the Q function when connected to the load L1, the value of the Q function when connected to the load L2,..., and the value of the Q function when connected to the load Ln.

In the reinforcement learning and evaluation of the energy storage device in the stationary energy storage device operation monitoring service 300, the action includes switching from a load connected to the energy storage device to another load different from the load.

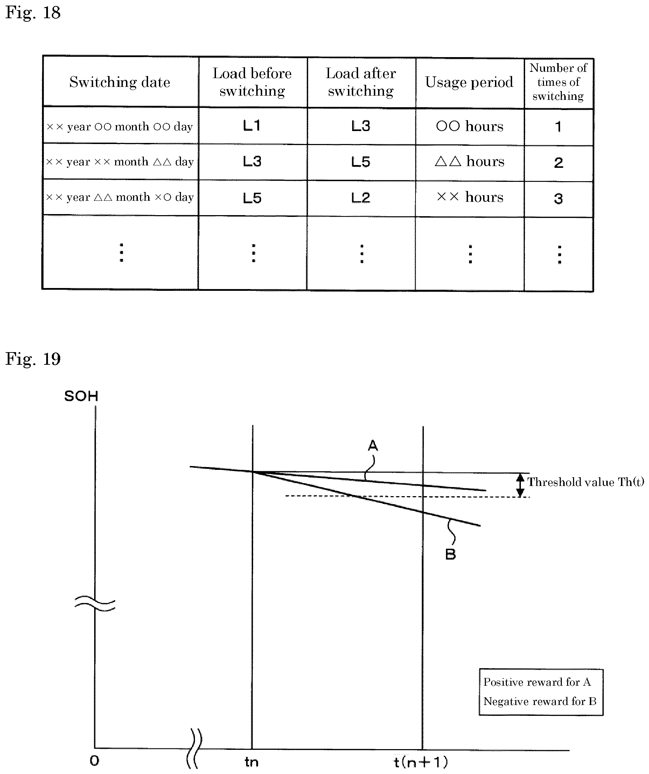

Fig. 18 is a schematic diagram showing an example of load switching. Fig. 18 shows a change in the load state of the energy storage device based on a command output by the control unit 51. As shown in Fig. 18, the switching information includes information such as the switching date, the load before switching, the load after switching, the usage period, and the number of times of switching for each energy storage device. The usage period is a period in which the energy storage device is used in the state of being connected to the load before switching.

The reward calculation unit 62 can calculate the reward based on the number of times of switching. For example, if priority is given to the operation of maintaining a high average SOH of the energy storage devices in the entire system including a plurality of energy storage devices, the calculation can be made so that the reward is not small or negative (penalty) even if the number of times of switching is large, at the expense of a slight cost increase due to the increase in the number of times of switching. On the other hand, if priority is given to the operation of reducing the switching cost for the entire system including a plurality of energy storage devices, the calculation can be made so that the reward is a relatively large value as the number of times of switching is smaller, at the expense of a slight decrease in the average SOH of the energy storage devices due to the reduction in the number of times of switching. As a result, optimum operation can be realized.

The action selection unit 63 updates the evaluation value table 64 based on the acquired state $s_{t+1}$ and reward $r_{t+1}$. More specifically, the action selection unit 63 updates the evaluation value table 64 in the direction of maximizing the reward for the action. This makes it possible to learn the action that is expected to have the maximum value in a certain state of the environment.

By repeating the above processing to repeat update of the evaluation value table 64, it is possible to learn the evaluation value table 64 that can maximize the reward.

Based on the updated evaluation value table 64 (that is, the learned evaluation value table 27), the processing unit 60 can execute an action including a change in the load state of the energy storage device to evaluate the state including SOH of the energy storage device. By learning load switching by reinforcement learning, the SOH of the energy storage device can be evaluated as a result of load switching. By evaluating each of the plurality of energy storage devices, the load of the energy storage devices can be optimally distributed in consideration of the degradation of the energy storage devices, and the cost can be reduced as a whole.

In all of the transportation/logistics/shipping service 100, the energy storage device replacement service 200, and the stationary energy storage device operation monitoring service 300, the reward calculation unit 62 has a function as a third reward calculation unit, and can calculate a reward based on the degree of decrease in SOH of the energy storage device.

Fig. 19 is a schematic diagram showing a first example of the state transition of reinforcement learning. In Fig. 19, the vertical axis represents SOH and the horizontal axis represents time. SOH represents the SOH of all energy storage devices. In Fig. 19, for convenience, two time points of time points tn and t(n + 1) are shown. The symbols A and B indicate an example of the learning process. The degree of decrease in SOH can be, for example, a decrease rate in the current SOH (SOH at time point t (n + 1) in the example of Fig. 19) with respect to the past SOH (SOH at time point tn in the example of Fig. 19). For example, as indicated by the symbol B, when the degree of decrease in SOH is greater than a threshold value Th(t) (when the decrease rate is large), the reward can be a negative value (penalty). Further, as indicated by the symbol A, when the degree of decrease in SOH is smaller than the threshold value Th(t) (when the decrease rate is small), the reward can be a positive value. As a result, optimum operation of the energy storage device can be realized while suppressing a decrease in SOH of the energy storage device.

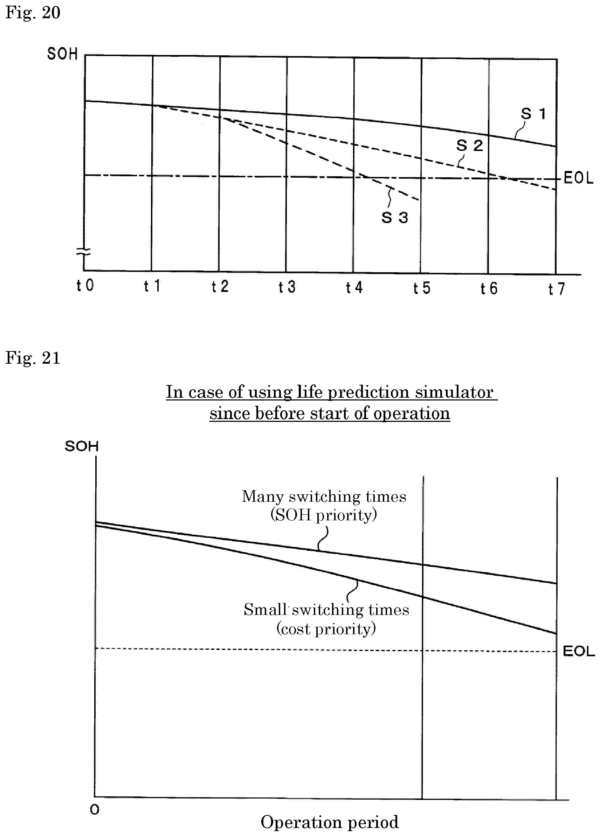

Fig. 20 is a schematic diagram showing a second example of the state transition of reinforcement learning. In Fig. 20, for convenience, eight time points of time points t0, t1, t2,..., and t7 are shown. SOH represents the SOH of all energy storage devices. In actual reinforcement learning, the number of time points also includes alternatives other than the example shown in Fig. 20. The symbols S1, S2, and S3 show an example of the learning process, and the learning of the symbol S 1 indicates the case where the SOH has not reached the EOL at the time point t7 (the state of the result of the action being selected and executed for each time point), the learning of the symbol S2 shows the case where the SOH has not reached the EOL at the time point t6 but has fallen below the EOL at the time point t7, and the learning of the symbol S3 shows the case where the SOH has fallen below the EOL at the time point t5 and the learning has once completed. Due to reinforcement learning, the action learned with the symbols S2 and S3 is not adopted, and the action learned with the symbol S1 is adopted as an example of the operation method.

Fig. 21 is a schematic diagram showing an example of the transition of SOH by the operation method obtained by reinforcement learning when the SOH estimation unit 61 is used since before the start of operation. Fig. 21 shows the case where the SOH estimation unit 61 is used from the start of operation. SOH represents the SOH of all energy storage devices. In the example of Fig. 21, the expected life is 10 years. In the figure, the graph indicated by "many switching times (SOH priority)" shows a case where the entire system including a plurality of energy storage devices is operated so that the average SOH of the energy storage devices can be maintained high. Further, the graph indicated by "small switching times (cost priority)" shows a case where operation is performed so that the switching cost can be reduced by reducing the switching (change) of the load state of each of the plurality of energy storage devices. Since the SOH estimation unit 61 is used from the start of operation, the optimum operation method can be estimated before operation. In addition, when a large cost is incurred in switching the load or environment, the optimum operation method including the cost required for switching can be obtained by reinforcement learning using the cost as a reward (penalty). Furthermore, by comparing the evaluation of each system in the optimum operation (for example, SOH after 10 years), the optimum system design can be selected at the beginning of the operation. Here, the system design includes, for example, the design of the type, number, rating, and the like of the energy storage devices used in the entire system, and also includes various parameters and the like.

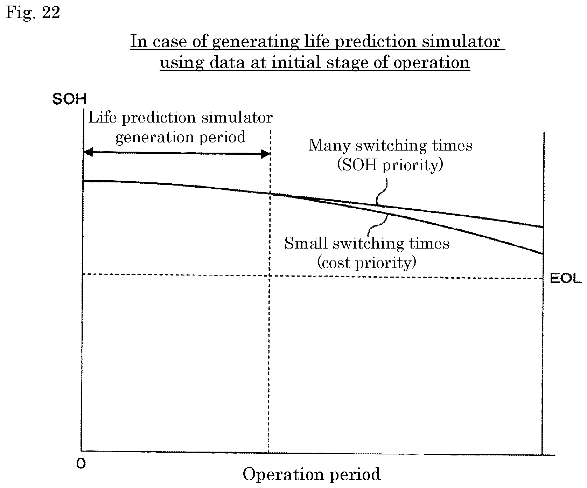

Fig. 22 is a schematic diagram showing an example of the transition of SOH by the operation method obtained by reinforcement learning when the life prediction simulator is generated using the data at the initial stage of operation. SOH represents the SOH of all energy storage devices. During the life prediction simulator generation period shown in Fig. 22, the control unit 51 acquires (collects) load power information and SOH of the energy storage device.

The control unit 51 has a function as a generation unit, and generates a life prediction simulator (also referred to as an SOH simulator) based on the acquired load power information and SOH. For example, after the start of operation of a system including a plurality of energy storage devices, the control unit 51 collects the acquired load power information and SOH of the energy storage device, and generates an SOH simulator that estimates the state including the collected SOH of the energy storage device with respect to the collected load power information. Specifically, parameters for estimating SOH are set. For example, the degradation value Qdeg of the energy storage device after a predetermined period can be expressed by the sum of the energization degradation value Qcur and the non-energization degradation value Qcnd, and when the elapsed time is expressed by t, the non-energization degradation value Qcnd can be obtained by, for example, $Qcnd = K1 \times \sqrt{t}$. The energization degradation value Qcur can be obtained by, for example, $Qcur = K2 \times (SOC \text{ fluctuation amount})$. Here, the parameters to be set are the coefficient K1 and the coefficient K2, and are represented by the SOC function. The SOH simulator may be generated in a development environment different from that of the energy storage device evaluation server 50.

As a result, it is possible to save the trouble of developing an SOH simulator that estimates the SOH of the energy storage device before operating the system. In addition, since the SOH simulator is generated by collecting the load power information and the state including the SOH of the energy storage device after the start of operation of the system, the development of a highly accurate SOH simulator suitable for the operating environment can be expected.

Further, after the SOH simulator is generated, the SOH after a lapse of a predetermined period in the future can be estimated. Further, if the degradation value after the lapse of the predetermined period is calculated based on the estimated SOH, the SOH after the lapse of the predetermined period can be further estimated. By repeating the estimation of SOH every predetermined period, it is also possible to estimate whether or not the energy storage device reaches the end of its life (whether or not SOH is EOL or less) at the expected life of the energy storage device (for example, 10 years, 15 years, etc.).

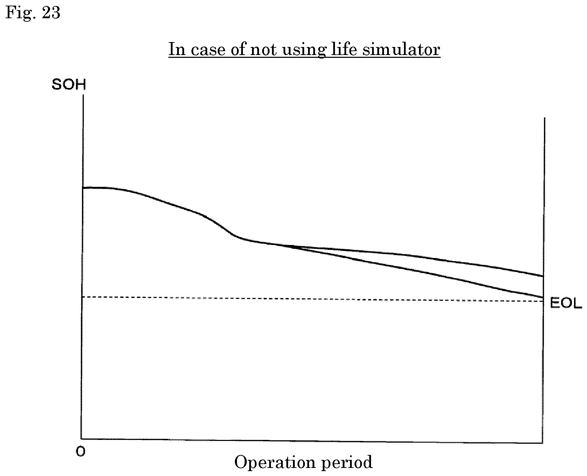

Fig. 23 is a schematic diagram showing an example of the SOH transition by the operation method obtained by reinforcement learning when the life prediction simulator is not used. SOH represents the SOH of all energy storage devices. It is possible to save the trouble of developing a life prediction simulator (SOH simulator). Since the SOH simulator is not used, the SOH of the energy storage device can be evaluated without depending on the accuracy of the SOH simulator. On the other hand, since it is not possible to search for the optimum operation method before the start of operation, it is not possible to perform optimum system design before the start of operation. In the initial stage of operation, since the operation search is performed only by reinforcement learning, in some cases, there is a possibility to select an undesired operation method in which the degree of decrease in SOH of the energy storage device becomes large. However, it is possible to expand the user's choices regarding the operation method.

Next, processing of reinforcement learning of the present embodiment will be described.

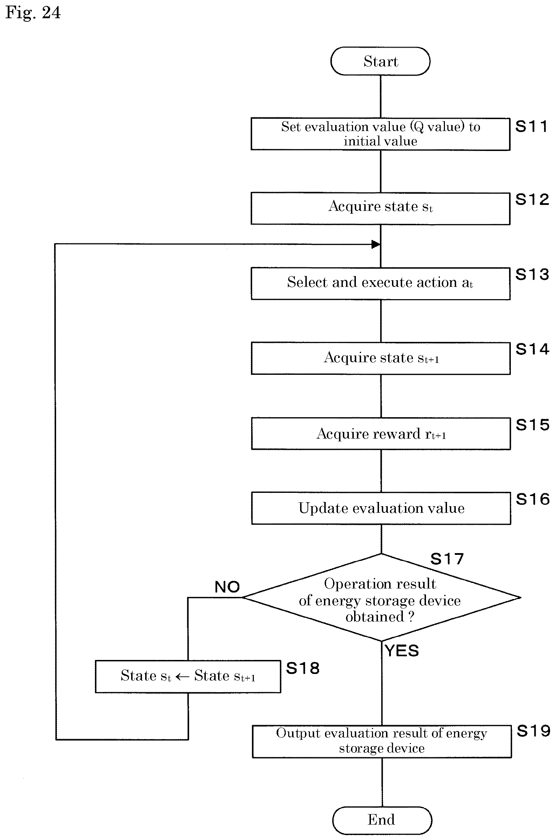

Fig. 24 is a flowchart showing an example of a processing procedure of reinforcement learning of the present embodiment. The processing unit 60 sets the evaluation value (Q value) of the evaluation value table 64 to the initial value (S11). For example, a random number can be used to set the initial value. The processing unit 60 acquires the state $s_t$ (S12), and selects and executes the action $a_t$ that can be taken in the state $s_t$ (S13). The processing unit 60 acquires the state $s_{t+1}$ obtained as a result of the action at (S14), and acquires the reward $r_{t+1}$ (S15). Note that the reward may be zero (no reward) in some cases.

The processing unit 60 updates the evaluation value of the evaluation value table 64 using the above Equation (2) or Equation (3) (S16), and determines whether or not the operation result of the energy storage device has been obtained (S17). When the operation result of the energy storage device has not been obtained (NO in S17), the processing unit 60 sets the state $s_{t+1}$ to the state $s_t$ (S18) and continues the processing after step S13. When the operation result of the energy storage device is obtained (YES in S17), the processing unit 60 outputs the evaluation result of the energy storage device (S19) and ends the processing.

The processing shown in Fig. 24 can be repeatedly performed using the changed system design parameters each time the system design parameters of the energy storage device are changed. That is, the processing unit 60 can acquire the system design parameters of the energy storage device. The system design parameters of the energy storage device include the type, number, rating, etc. of the energy storage device used in the entire system, and, for example, include various types of parameters necessary for system design such as the configuration or number of energy storage modules, the configuration or number of banks, and the like. The design parameters of the energy storage device are set in advance prior to the actual operation of the system. By evaluating the state including SOH of the energy storage device according to the design parameters, it is possible to grasp, for example, what kind of design parameters should be adopted to obtain the optimum operation method of the entire system in consideration of the degradation of the energy storage device.

The processing unit 60 can be configured, for example, by combining hardware such as a CPU (for example, a multi-processor in which a plurality of processor cores are mounted), a GPU (Graphics Processing Units), a DSP (Digital Signal Processors), and an FPGA (Field-Programmable Gate Arrays). The processing unit 60 may be configured by a virtual machine, a quantum computer, or the like. The agent is a virtual machine that exists on the computer, and the state of the agent is changed by parameters and the like.

The control unit 51 and the processing unit 60 of the present embodiment can also be realized by using a general-purpose computer including a CPU (processor), a GPU, a RAM (memory), and the like. For example, a computer program or data (for example, a learned Q function or Q value) recorded on a recording medium MR (for example, an optically readable disk storage medium such as a CD-ROM) as shown in Fig. 2 can be read by the recording medium reading unit 54 (for example, an optical disk drive) and stored in RAM. It may be stored on a hard disk (not shown) and stored in RAM when a computer program is executed. By loading a computer program that defines the procedure of each processing as shown in Fig. 24 into the RAM (memory) provided in the computer and executing the computer program by the CPU (processor), it is possible to realize the control unit 51 and the processing unit 60 on the computer. The Q function or Q value obtained by the computer program in which the reinforcement learning algorithm according to the present embodiment is defined and the reinforcement learning may be recorded on a recording medium and distributed, or can be distributed to a required device through the communication network 1 and installed.

In the above-described embodiment, Q-learning has been described as an example of reinforcement learning, but another reinforcement learning algorithm such as another TD learning (Temporal Difference Learning) may be used instead. For example, a learning method such as Q-learning that updates the value of a state instead of updating the value of an action may be used. In this method, the value V ($s_t$) of the current state St is updated by the formula V ($s_t$) < -V ($s_t$) + $\alpha \cdot \delta t$. Here, $\delta t = r_{t+1} + \gamma \cdot$ V ($s_{t+1}$) - V ($s_t$), $\alpha$ is the learning rate, and $\delta t$ is the TD error.

The above-described embodiment has the configuration of searching for the optimum operation method of the system including a plurality of energy storage devices used in the transportation/logistics/shipping service 100, the energy storage device replacement service 200, and the stationary energy storage device operation monitoring service 300, but this embodiment can also be provided to an energy management system (EMS). In EMS, a charge/discharge algorithm for a plurality of energy storage devices in the EMS is required to achieve the target value of power control. The EMS includes, as a main scope, CEMS (Community Energy Management System) that manages towns and regions, BEMS (Building Energy Management System) for the entire building, FEMS (Factory Energy Management System) for factories, HEMS (Home Energy Management System) for homes, and the like. By applying this embodiment to these various EMSs, it is possible to obtain actions including a change in the load state (for example, charge/discharge algorithm) with respect to the state including SOH of the energy storage device used in the EMS by reinforcement learning, and to evaluate the SOH of the energy storage device as a result of actions including a change in the load state. By evaluating each of the plurality of energy storage devices, it is possible to optimally distribute the load of the energy storage devices in consideration of the degradation of the energy storage devices, and to reduce the cost of each EMS as a whole.

The above-described embodiments are exemplifications in all respects, and are not restrictive. The scope of the present invention is shown by the claims, and includes meanings equivalent to the claims and all modifications within the scope.

DESCRIPTION OF REFERENCE SIGNS

| 50: | energy storage device evaluation server |
| 51: | control unit |
| 52: | communication unit |
| 53: | storage unit |
| 54: | recording medium reading unit |
| 60: | processing unit |
| 61: | SOH estimation unit |
| 62: | reward calculation unit |
| 63: | action selection unit |
| 64: | evaluation value table |

**Claims**

1.  An energy storage device evaluation device, comprising:

    an action selection unit that selects an action including a change in a load state of an energy storage device based on action evaluation information;
    a state acquisition unit that acquires a state of the energy storage device when the action selected by the action selection unit is executed;
    a reward acquisition unit that acquires a reward when the action selected by the action selection unit is executed;
    an update unit that updates the action evaluation information based on the state acquired by the state acquisition unit and the reward acquired by the reward acquisition unit; and
    an evaluation unit that evaluates the state of the energy storage device by executing an action based on the action evaluation information updated by the update unit.

2.  The energy storage device evaluation device according to claim 1, wherein

    a moving object mounted with the energy storage device is designed to move within one of a plurality of moving areas; and
    the action includes switching from a moving area in which the moving object moves to another moving area different from the moving area.

3.  The energy storage device evaluation device according to claim 2, further comprising a first reward calculation unit that calculates a reward based on a distance between moving object areas due to the switching of the moving area, wherein
    the reward acquisition unit acquires the reward calculated by the first reward calculation unit.

4.  The energy storage device evaluation device according to claim 1, wherein the action includes switching between a mounted state in which the energy storage device is mounted on the moving object and a stored state in which the energy storage device is removed from the moving object.

5.  The energy storage device evaluation device according to claim 1, wherein:

    the energy storage device is connected to one of a plurality of loads; and
    the action includes switching from a load connected to the energy storage device to another load different from the load.

6.  The energy storage device evaluation device according to any one of claims 2 to 5, further comprising a second reward calculation unit that calculates a reward based on the number of times of switching, wherein

the reward acquisition unit acquires the reward calculated by the second reward calculation unit.

7. The energy storage device evaluation device according to any one of claims 1 to 6, further comprising a third reward calculation unit that calculates a reward based on a degree of decrease in SOH of the energy storage device, wherein the reward acquisition unit acquires the reward calculated by the third reward calculation unit.

8. The energy storage device evaluation device according to any one of claims 1 to 7, further comprising a fourth reward calculation unit that calculates a reward based on whether or not a state of the energy storage device has reached an end of life, wherein the reward acquisition unit acquires the reward calculated by the fourth reward calculation unit.

9. The energy storage device evaluation device according to any one of claims 1 to 8, further comprising:

   a power information acquisition unit that acquires load power information of the energy storage device;
   an SOC transition estimation unit that estimates transition of an SOC of the energy storage device based on the load power information acquired by the power information acquisition unit and the action selected by the action selection unit; and
   an SOH estimation unit that estimates an SOH of the energy storage device based on the transition of an SOC estimated by the SOC transition estimation unit, wherein
   the evaluation unit evaluates a state including the SOH of the energy storage device based on the SOH estimated by the SOH estimation unit.

10. The energy storage device evaluation device according to any one of claims 1 to 8, further comprising:

    a power information acquisition unit that acquires load power information of the energy storage device;
    an SOH acquisition unit that acquires an SOH of the energy storage device; and
    a generation unit that generates an SOH estimation unit that estimates the SOH of the energy storage device based on the load power information acquired by the power information acquisition unit and the SOH acquired by the SOH acquisition unit, wherein
    the evaluation unit evaluates a state including the SOH of the energy storage device based on SOH estimation of the SOH estimation unit generated by the generation unit.

11. The energy storage device evaluation device according to claim 9 or 10, further comprising a temperature information acquisition unit that acquires environmental temperature information of the energy storage device, wherein the SOH estimation unit estimates the SOH of the energy storage device based on the environmental temperature information.

12. The energy storage device evaluation device according to any one of claims 1 to 11, further comprising a parameter acquisition unit that acquires a design parameter of the energy storage device, wherein the evaluation unit evaluates the state of the energy storage device according to the design parameter acquired by the parameter acquisition unit.

13. The energy storage device evaluation device according to any one of claims 1 to 12, further comprising an output unit that outputs a command of an action including a change in the load state of the energy storage device based on an evaluation result of the state of the energy storage device by the evaluation unit.

14. A computer program causing a computer to execute the processing of:

    selecting an action including a change in a load state of an energy storage device based on action evaluation information;
    acquiring a state of the energy storage device when the selected action is executed;
    acquiring a reward when the selected action is executed;
    updating the action evaluation information based on the acquired state and reward; and
    evaluating the state of the energy storage device by executing an action based on the updated action evaluation information.

15. An energy storage device evaluation method, comprising:

selecting an action including a change in a load state of an energy storage device based on action evaluation information;

acquiring a state of the energy storage device when the selected action is executed;

acquiring a reward when the selected action is executed;

updating the action evaluation information based on the acquired state and reward; and

evaluating the state of the energy storage device by executing an action based on the updated action evaluation information.

**16.** A learning method, comprising:

selecting an action including a change in a load state of an energy storage device based on action evaluation information;

acquiring a state of the energy storage device when the selected action is executed;

acquiring a reward when the selected action is executed; and

updating the action evaluation information based on the acquired reward to learn an action corresponding to the state of the energy storage device.

**17.** A generation method, comprising:

selecting an action including a change in a load state of an energy storage device based on action evaluation information;

acquiring a state of the energy storage device when the selected action is executed;

acquiring a reward when the selected action is executed; and

updating the action evaluation information based on the acquired reward to generate the action evaluation information.

Fig. 1

Transportation/logistics/shipping service — 100
- Bus — 110
- Flying vehicle — 140
- Truck — 120
- Taxi — 130
- Server — 101

Energy storage device replacement service — 200
- Motorcycle — 210
- Rental car — 220
- Server — 201

Stationary energy storage device operation monitoring service — 300
- Power generation facility — 310
- Power demand facility — 320
- Server — 301

1

Energy storage device evaluation server — 50

EP 3 875 976 A1

Fig. 2

~50

Energy storage device
evaluation server

~51

Control unit

~52

Communication
unit

~60

Processing unit

~61

SOH estimation unit

~53

Storage unit

~62

Reward calculation
unit

~63

Action selection unit

MR

~54

Recording medium
reading unit

~64

Evaluation value
table

Fig. 3A

In case of heavy loading

Fig. 3B

In case of light loading

Fig. 4

Temperature (%)

Fig. 5

Load pattern

Temperature pattern

Action

61

SOH estimation unit

Estimation

SOC transition

Degradation estimation

$SOH_t$

Degradation value

$SOH_{t+1}$

EP 3 875 976 A1

Fig. 6

Fig. 7

Environment

61

State s$_{t+1}$

SOH estimation unit

State s$_t$

62

Reward calculation unit

Action a$_t$

Reward r$_{t+1}$

Agent

63

Action selection unit

64

Evaluation value table

Fig. 8

Service area

Area C7

Area C4

Area C10

Area C2

Area C8

Area C5

Area C1

Area C3

Area C6

Area C9

EP 3 875 976 A1

Fig. 9

| Service area | Vehicle ID |
|---|---|
| Area C1 | V0001~V0100 |
| Area C2 | V0101~V0200 |
| Area C3 | V0201~V0300 |
| ⋮ | ⋮ |

Fig. 10

| Vehicle ID | Energy storage device |
|---|---|
| V0001 | B0304 |
| V0002 | B0054 |
| V0003 | B0013 |
| ⋮ | ⋮ |

Fig. 11

| State ╲ Action | Arrangement a {C2, C1, C3, ···, Cn} | Arrangement b {C3, C2, C1, ···, Cn} | ··· |
|---|---|---|---|
| $SOHA[SOH_1, SOH_2, SOH_3, ···, SOH_n]$ | QAa | QAb | ··· |
| $SOHB[SOH_1, SOH_2, SOH_3, ···, SOH_n]$ | QBa | QBb | ··· |
| ⋮ | ⋮ | ⋮ | ⋮ |
| $SOHm[SOH_1, SOH_2, SOH_3, ···, SOH_n]$ | Qma | Qmb | ··· |

EP 3 875 976 A1

Fig. 12

| State \ Action | Arrangement a {C2, C1, C3, C4, C5} | Arrangement b {C3, C2, C1, C4, C5} | ... |
|---|---|---|---|
| SOHA[100, 90, 100, 98, 99] | QAa | QAb | ... |
| ⋮ | ⋮ | ⋮ | ⋮ |

Fig. 13

State $s_t$ — Input layer 601 — Intermediate layer 602 — Output layer 603 — Action $a_t$

60

SOHA

SOHB

SOHC

SOHm

Value of Q function when changed to arrangement pattern a

Value of Q function when changed to arrangement pattern b

Fig. 14

| Switching date | Arrangement pattern before switching | Arrangement pattern after switching | Distance between arrangement patterns | Number of times of switching |
|---|---|---|---|---|
| ○× year ○× month ○× day | d | a | ○×km | 1 |
| △× year △× month △× day | a | f | △×km | 2 |
| △○ year △○ month △○ day | f | b | △○km | 3 |
| ⋮ | ⋮ | ⋮ | ⋮ | ⋮ |

Fig. 15

Fig. 16

| Switching date | State | Period | Number of times of switching |
|---|---|---|---|
| ◯◯ year ◯◯ month ◯◯ day | Mounted | ◯◯ hours | — |
| △△ year △△ month △△ day | Stored | △△ hours | 1 |
| ×× year ×× month ×× day | Mounted | ×× hours | 2 |
| ⋮ | ⋮ | ⋮ | ⋮ |

Fig. 17

Fig. 18

| Switching date | Load before switching | Load after switching | Usage period | Number of times of switching |
|---|---|---|---|---|
| ×× year ○○ month ○○ day | L1 | L3 | ○○ hours | 1 |
| ×× year ×× month △△ day | L3 | L5 | △△ hours | 2 |
| ×× year △△ month ×○ day | L5 | L2 | ×× hours | 3 |
| ⋮ | ⋮ | ⋮ | ⋮ | ⋮ |

Fig. 19

Fig. 20

Fig. 21

In case of using life prediction simulator
since before start of operation

Fig. 22

In case of generating life prediction simulator
using data at initial stage of operation

Fig. 23

In case of not using life simulator

SOH

EOL

O

Operation period

Fig. 24

```
                              ┌─────────────┐
                              │    Start    │
                              └─────────────┘
                                     │
                    ┌────────────────────────────────┐  S11
                    │ Set evaluation value (Q value) to │
                    │         initial value          │
                    └────────────────────────────────┘
                                     │
                    ┌────────────────────────────────┐  S12
                    │        Acquire state sₜ        │
                    └────────────────────────────────┘
                                     │
       ┌──────────────────→─────────┤
       │            ┌────────────────────────────────┐  S13
       │            │    Select and execute action aₜ │
       │            └────────────────────────────────┘
       │                             │
       │            ┌────────────────────────────────┐  S14
       │            │      Acquire state sₜ₊₁        │
       │            └────────────────────────────────┘
       │                             │
       │            ┌────────────────────────────────┐  S15
       │            │      Acquire reward rₜ₊₁       │
       │            └────────────────────────────────┘
       │                             │
       │            ┌────────────────────────────────┐  S16
       │            │      Update evaluation value    │
       │            └────────────────────────────────┘
       │                             │          S17
       │                     ◇───────────────◇
       │              NO    ╱  Operation result ╲
       │        ┌──────────◇  of energy storage  ◇
       │        │           ╲      device        ╱
       │        │            ╲    obtained ?   ╱
       │        │             ◇───────────────◇
       │        │                     │ YES
       │   ┌──────────────────┐  S18  │
       │   │ State sₜ ← State sₜ₊₁ │   │
       │   └──────────────────┘      │
       │        │                     │
       └────────┘         ┌────────────────────────────────┐  S19
                          │ Output evaluation result of energy│
                          │         storage device         │
                          └────────────────────────────────┘
                                     │
                              ┌─────────────┐
                              │     End     │
                              └─────────────┘
```

<div style="text-align:center">**INTERNATIONAL SEARCH REPORT**</div>

| International application No. |
| --- |
| PCT/JP2019/042707 |

**A. CLASSIFICATION OF SUBJECT MATTER**
Int.Cl. G01R31/392(2019.01)i, B60L50/50(2019.01)i, G01R31/367(2019.01)i,
  G06Q10/04(2012.01)i, H01M10/48(2006.01)i, H02J7/00(2006.01)i

According to International Patent Classification (IPC) or to both national classification and IPC

**B. FIELDS SEARCHED**

Minimum documentation searched (classification system followed by classification symbols)
Int.Cl. G01R31/392, B60L50/50, G01R31/367, G06Q10/04, H01M10/48,
  H02J7/00, G01R31/382, G01R31/385

Documentation searched other than minimum documentation to the extent that such documents are included in the fields searched
Published examined utility model applications of Japan 1922–1996
Published unexamined utility model applications of Japan 1971–2019
Registered utility model specifications of Japan 1996–2019
Published registered utility model applications of Japan 1994–2019

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X<br><br>Y<br>A | JP 2016-77139 A (PANASONIC IP MANAGEMENT CO., LTD.) 12 May 2016, paragraphs [0001], [0007]–[0008], [0015], [0055]–[0221], fig. 1-16 & US 2016/0105044 A1, fig. 1-16, paragraphs [0002], [0007]–[0008], [0035], [0076]–[0247] & EP 3007310 A2 | 1, 5, 7, 10–11, 13–15, 17<br>9<br>2-4, 6, 8, 12, 16 |

☒ Further documents are listed in the continuation of Box C.  ☐ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| 18 December 2019 (18.12.2019) | 07 January 2020 (07.01.2020) |

| Name and mailing address of the ISA/<br>  Japan Patent Office<br>  3-4-3, Kasumigaseki, Chiyoda-ku,<br>  Tokyo 100-8915, Japan | Authorized officer<br><br>Telephone No. |
| --- | --- |

Form PCT/ISA/210 (second sheet) (January 2015)

**INTERNATIONAL SEARCH REPORT**

| International application No. |
|---|
| PCT/JP2019/042707 |

C (Continuation).   DOCUMENTS CONSIDERED TO BE RELEVANT

| Category* | Citation of document, with indication, where appropriate, of the relevant passages | Relevant to claim No. |
|---|---|---|
| X<br>A | WO 2014/046179 A1 (SEKISUI CHEMICAL CO., LTD.) 27 March 2014, paragraphs [0001], [0007], [0015]-[0107], fig. 1-15 & US 2015/0229150 A1, fig. 1-15, paragraphs [0001], [0032]-[0205] & EP 2899837 A1 & KR 10-2015-0058172 A | 1, 8, 13-15, 17<br>2-7, 9-12, 10 |
| X<br>A | JP 2012-29451 A (NICHICON CORPORATION) 09 February 2012, paragraphs [0001]-[0002], [0019]-[0037], [0040]-[0127], fig. 1-13 (Family: none) | 1, 4, 14-15, 17<br>2-3, 5-13, 16 |
| Y<br>A | WO 2014/083856 A1 (SANYO ELECTRIC CO., LTD.) 05 June 2014, paragraphs [0001], [0037]-[0038], fig. 1 & US 2015/0293183 A1, fig. 1, paragraphs [0001], [0039] | 9<br>1-8, 10-17 |
| A | JP 2016-73042 A (SEKISUI CHEMICAL CO., LTD.) 09 May 2016, entire text, all drawings (Family: none) | 1-17 |
| A | JP 2015-92328 A (TOSHIBA CORP.) 14 May 2015, entire text, all drawings & WO 2015/049969 A1 & CN 105637543 A | 1-17 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017046498 A